# EUROPEAN PATENT SPECIFICATION

(11) **EP 2 137 847 B1**
(45) Date of publication and mention of the grant of the patent: **27.06.2018**
(21) Application number: 08743611.9
(22) Date of filing: 28.02.2008
(51) Int. Cl.: H04B 10/00, H04J 14/02, H03M 9/00

(54) **MULTI-MODE INTEGRATED CIRCUIT FOR USE IN OPTOELECTRONIC DEVICES**
INTEGRIERTER SCHALTKREIS MIT MEHREREN MODI FÜR OPTOELEKTRONISCHE GERÄTE
CIRCUIT INTÉGRÉ MULTIMODE POUR UNE UTILISATION DANS DES DISPOSITIFS OPTOÉLECTRONIQUES

(30) Priority: 28.02.2007 US 892132 P; 28.02.2007 US 892065 P; 28.02.2007 US 892143 P; 28.02.2007 US 892181 P; 28.02.2007 US 892154 P; 28.02.2007 US 892112 P; 28.02.2007 US 892060 P
(43) Date of publication of application: 30.12.2009
(73) Proprietor: Finisar Corporation, Sunnyvale, CA 94089 (US)
(72) Inventor: COLE, Christopher, Redwood City, CA 94062 (US)
(74) Representative: Foster, Mark Charles
(86) International application number: PCT/US2008/055392
(87) International publication number: WO 2008/106626

(56) References cited:
- WO-A2-00/36780
- US-A1- 2002 034 197
- US-A1- 2003 179 771
- US-A1- 2005 089 126
- US-A1- 2005 089 126
- US-A1- 2005 169 585
- US-A1- 2005 169 585
- 'SerDes Framer Interface Level5 (SFI-5): Implementation Agreement for 40Gb/s Interface for Physical Layer Devices' OIF-SF15-01.02 29 January 2002, page 8, 17 - 19, XP008117653

## Description

### BACKGROUND OF THE INVENTION

### 1. The Field of the Invention

The present invention relates generally to the field of high speed data transmission. More particularly, embodiments of the invention relate to systems and methods for serializing and deserializing electrical and/or optical signals in numerous and varied environments to achieve high speed data transmission.

### 2. The Relevant Technology

Computing and networking technology have transformed our world. As the amount of information communicated over networks has increased, high speed transmission becomes ever more critical. Many high speed data transmission networks rely on optical transceivers and similar optoelectronic devices for facilitating transmission and reception of digital data. Optical networks are thus found in a wide variety of high speed applications ranging from modest Local Area Networks (LANs) to the backbone of the Internet.

Many optoelectronic device architectures use a higher signaling rate and lower signal count to send optical signals over an optical fiber than to receive electrical signals from a line card on which the devices are used. This requires the devices to convert from the higher optical data rate to the lower electrical data rate, and vice versa. The integrated circuit ("IC") component that performs this function is called a serializer/deserializer, also commonly referred to as a SerDes.

The serializer portion of the SerDes receives two or more parallel data signals from a line card at a first signal rate and provides as output one or more serial data signals at a second signal rate. The number of output serial data signals is usually less than the number of input parallel data signals, although the same amount of data is conveyed by the output serial data signals. Consequently, the signal rate of one of the parallel data signals is less than the signal rate of one of the serial data signals.

The deserializer portion of the SerDes performs a function that is the reverse of the function performed by the serializer. The deserializer receives one or more serial data signals at the second signal rate and provides two or more parallel data signals to the line card at the first signal rate.
An arrangement of this type is disclosed in WO0036780.
Typically, a different SerDes is required for different optoelectronic device architectures since the functions performed by the SerDes depend on the device architecture. For instance, a 40G transponder architecture may implement the SFI5.1 protocol to convert between sixteen parallel data signals at a 2.5 gigabit per second ("G") data rate per signal and one 40G serial signal. In contrast, a 10GE transponder architecture may implement the XAUI protocol to convert between four parallel 2.5G data signals and one 10G serial signal. Accordingly, a need exists in the art for a multi-mode SerDes which supports operation in different architectures and at increased transmission speeds.

### BRIEF SUMMARY OF THE INVENTION

The present invention provides a SerDes as defined in claim 1 and a multi-channel optoelectronic device as defined in claim 8.

Embodiments of the present invention are directed to systems and methods for serializing and deserializing electrical data signals. In particular, embodiments of the invention enable the use of a multi-mode SerDes, serializer, and/or deserializer in 100GE mode. In other embodiments, the multimode SerDes, serializer, or deserializer can additionally be used in one or more other modes, such as 40G VSR mode, 43G transport mode, and 43G DQPSK mode. In this manner, engineering resources and non-recurring engineering costs are significantly reduced, as compared to developing numerous single- mode serializers and/or deserializers for specific device architectures. Additionally, since one multi-mode serializer and/or deserializer addresses the requirements of multiple single-mode serializer and/or deserializer markets, the resulting higher overall volumes reduce the cost of the IC chip sets and bring in a greater return on research and development investment.

One embodiment of a multi-mode serializer/deserializer ("SerDes") is designed to operate in at least 100G mode. In 100G mode, the serializer/deserializer ("SerDes") can convert between 10 X 10G, 12 X 8.33G or 8 X 12.5G parallel data lanes and 4 X 25G or 5 X 20G serial data lanes. The multi-mode SerDes may additionally operate in one or more other modes. In 40G VSR mode, the SerDes can convert between 5 X 10G encoded parallel data lanes and a 1 X 40G serial data lane. In 43G transport mode, the SerDes can convert between 5 X 10.75G encoded parallel data lanes and a 1 X 43G serial data lane with a 21.5 gigahertz ("GHz") clock signal. In 43G DQPSK mode, the SerDes can convert between 5 X 10.75G encoded parallel data lanes and 2 X 21.5G serial data lanes with a 21.5 GHz clock signal.

In one embodiment of the invention, a multi-mode serializer includes input nodes for receiving parallel data signals, a main multiplexing block for converting the parallel data signals to serial data signals, final retiming flip flops for clocking the serial data signals out of the main multiplexing block, and a dynamic high speed multiplexer for optionally multiplexing two of the serial data signals during 40G VSR mode and 43G transport mode into a single serial signal. A dual-mode bypass block between the input nodes and the main multiplexing block optionally converts five encoded parallel data signals to four parallel data signals during operation in 40G VSR, 43G transport and 43G DQPSK modes.

In another embodiment of the invention, a multi-mode deserializer includes input nodes for receiving one or more high speed serial data signals, an input dynamic high speed demultiplexer for optionally demultiplexing one serial data signal during 40G VSR mode and/or 43G transport mode into two data signals, initial retiming flip flops, a main demultiplexing block, a dual-mode bypass block and final retiming flip flops. The initial retiming flip flops are used to clock the serial data signals into the main demultiplexing block and the main demultiplexing block converts the serial data signals to parallel data signals. The final retiming flip flops are used to clock the parallel data signals out of the demultiplexing block. The dual-mode bypass block is between the demultiplexing block and the final retiming flip flops and it optionally converts four parallel data signals to five encoded parallel data signals during operation in 40G VSR, 43G transport and 43G DQPSK modes.

These and other advantages and features of the present invention will become more fully apparent from the following description and appended claims, or may be learned by the practice of the invention as set forth hereinafter.

### BRIEF DESCRIPTION OF THE DRAWINGS

To further clarify the above and other advantages and features of the present invention, a more particular description of the invention will be rendered by reference to specific embodiments thereof which are illustrated in the appended drawings. It is appreciated that these drawings depict only typical embodiments of the invention and are therefore not to be considered limiting of its scope. The invention will be described and explained with additional specificity and detail through the use of the accompanying drawings in which:
Figure 1 illustrates an example system architecture in which embodiments of the invention may be practiced;
Figure 2 illustrates one embodiment of a 100G device architecture in which embodiments of the invention may be implemented;
Figure 3 illustrates one embodiment of a 40G VSR device architecture in which embodiments of the invention may be implemented;
Figure 4 illustrates one embodiment of a 43G transport device architecture in which embodiments of the invention may be implemented;
Figure 5 illustrates one embodiment of a 43G DQPSK device architecture in which embodiments of the invention may be implemented;
Figure 6A illustrates a simplified block view of one embodiment of a multi-mode serializer;
Figure 6B illustrates one embodiment of the multi-mode serializer of Figure 6A;
Figure 7 illustrates an embodiment of a dual-mode multiplexer block which may be implemented in a multi-mode serializer;
Figure 8A illustrates a simplified block view of one embodiment of a multi-mode deserializer;
Figure 8B illustrates one embodiment of the multi-mode deserializer of Figure 8A; and
Figure 9 illustrates an embodiment of a dual-mode demultiplexer block which may be implemented in a multi-mode deserializer.

### DETAILED DESCRIPTION OF THE PREFERRED EMBODIMENTS

Reference will now be made to the drawings to describe various aspects of exemplary embodiments of the invention. It should be understood that the drawings are diagrammatic and schematic representations of such exemplary embodiments and, accordingly, are not limiting of the scope of the present invention, nor are the drawings necessarily drawn to scale.

In general, embodiments of the invention are concerned with the serialization and deserialization of electrical and/or optical signals, also referred to herein as data streams, lanes and channels. More particularly, embodiments of the invention enable the use of a multi-mode IC architecture having one or more serializers and/or deserializers that supports operation in two or more different applications, including, but not limited to, 40G and 100G optoelectronic devices. Further, some of the examples herein are described with respect to particular interfaces, particular types of light emitters or lasers, and/or with respect to specific data rates. One of skill in the art can appreciate, with the benefit of the present disclosure, that other data rates, lasers, and/or interfaces may be implemented in the architectures described herein.

The present invention can be implemented in various system architectures in which data is transmitted and received, including architectures that include optoelectronic devices. As used herein, the term "optoelectronic device" includes devices having both optical and electrical components. Examples of optoelectronic devices include, but are not limited to transponders, transceivers, transmitters, and/or receivers. The optoelectronic devices can exemplarily be used in telecommunications networks, local area networks, metro area networks, storage area networks, wide area networks, and the like and can be configured to conform with one or more standardized form factors or multi-source agreements (MSAs). It will be appreciated, however, that the optoelectronic devices need not comply with standardized form factor requirements and may have any size or configuration necessary according to a particular design.

The principles of the present invention may be implemented in optoelectronic devices of any form factor currently available or that may be developed in the future for 40G, 43G and/or 100G signaling, without restriction. As used herein, the terms "40G", "43G", and "100G" are rounded approximations of signaling rates and have the meanings commonly understood by those of skill in the art. In particular, the terms 40G, 43G, and 100G refer to data rates substantially equal to 40G, 43G, and 100G, respectively. For instance, the term "40G" may be understood to refer to 39.813 gigabits per second, the term "43G"may be understood to refer to 43.108 gigabits per second, and the term "100G" may be understood to refer to 103.125 gigabits per second. Other terms applied to signaling rates described herein include 21.5G, 10G, 12.5, 8.33G, and the like. These terms similarly have the meanings commonly understood by those of skill in the art.

### I. Example Operating Environment

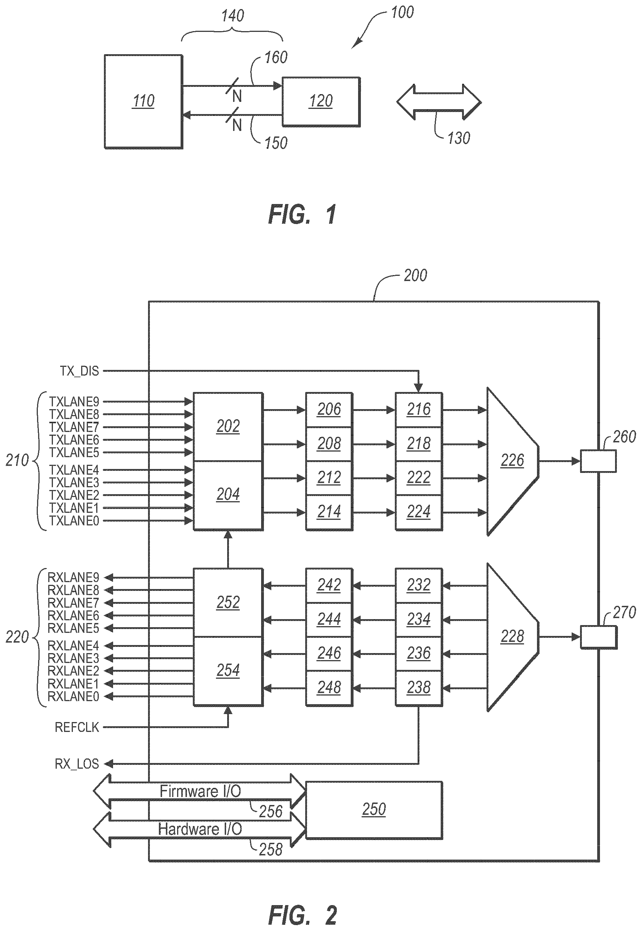

Figure 1 illustrates an example system architecture 100 in which embodiments of the invention may be implemented. The system 100 facilitates bidirectional (e.g., duplex) communication (optical and/or electrical) between a host device 110, such as a media access controller ("MAC"), and an optoelectronic device 120, such as an optical transceiver or transponder. Additionally, the system 100 facilitates multi-channel or single channel bidirectional optical communication over the duplex fibers 130. However, the principles of the present invention are equally applicable in unidirectional (e.g., simplex) systems. Embodiments of the invention can be implemented in optoelectronic devices utilizing various multi-channel optical transmission techniques, including wavelength division multiplexing ("WDM"), parallel optics and in-phase and quadrature-phase ("I and Q") channels.

In this example, an electrical interface 140 between the host device 110 and the device 120 is provided for conveying data between the host and the device. The electrical interface 140 includes a plurality of receive lanes 150, the number of receive lanes represented by the letter "N," and an equivalent number of transmit lanes 160. In other words, the electrical interface includes N I/O electrical lanes. The number of lanes and the data rate per lane determines the aggregate data rate. In one embodiment of the invention, a 100G aggregate data rate (in each direction) is achieved with ten I/O lanes operating at 10G per lane, or 10 X 10G I/O lanes. A 100G aggregate data rate may also be achieved with 12 X 8.33G I/O lanes, 8 X 12.5G I/O lanes, or numerous other configurations. In another embodiment of the invention, a 40G aggregate data rate is achieved with 5 X 10G I/O lanes (four data lanes and a fifth deskew lane carrying redundant data). In yet another embodiment of the invention, a 43G aggregate data rate is achieved with 5 X 10.75G I/O lanes (four data lanes and a fifth deskew lane carrying redundant data). Of course, other configurations for the electrical interface 140 may alternately or additionally be implemented.

In operation, the device 120 receives N transmit signals 160 from the host device 110 and emits one or more optical signals representative of the N transmit signals onto duplex optical fibers 130. The device 120 can also receive one or more optical signals from the duplex optical fibers 130 and provide to the host device 110 N receive signals 150 representative of the received optical signals.

In various embodiments of the invention, there are fewer optical signals than electrical signals (both transmit and receive) carrying an equivalent amount of data. Consequently, the optical signals have a higher data rate than the electrical signals and the device 120 includes one or more SerDes ICs to convert between the two data rates. Embodiments of the invention contemplate a multi-mode SerDes IC that supports operation in at least two different modes, such as 100G mode (e.g., in devices with 100G electrical I/O), 40G mode and 43G mode.

### II. Example Optoelectronic Devices

Figure 2 illustrates an example multi-channel optoelectronic device 200 in which embodiments of a multi-mode SerDes IC may be implemented. As used herein, the term "multi-channel" as applied to an optoelectronic device refers to a device with multiple bidirectional or unidirectional optical channels. While the module 200 will be described in some detail, the module 200 is described by way of illustration only, and not by way of restricting the scope of the invention. In particular, some of the components used to facilitate one type of multi-channel transmission technique may or may not be necessary in another type of multi-channel transmission technique. For instance, in the present embodiment, the device 200 implements some form of wavelength division multiplexing ("WDM") to transmit and receive multiple optical data channels over optical fiber 260, 270, requiring an optical multiplexer ("MUX") for transmission and an optical demultiplexer ("DEMUX") for reception of optical signals. However, the invention may also be utilized in multi-channel optoelectronic devices implementing other multi-channel transmission techniques, such as parallel optics and quadrature multiplexing, including differential quadrature phase shift keying ("DQPSK"). Additionally, the invention may be implemented in single-channel optoelectronic devices. Thus, the fiber optic cables 260, 270 may comprise single mode fiber ("SMF"), multimode optical fibers ("MMF"), parallel ribbon fibers, and the like or any combination thereof.

The module 200 includes a 100G electrical interface for receiving 10 X 10G transmit data channels 210 (TXLANE0 - TXLANE9) from a host and for providing 10 X 10G receive data channels 220 (RXLANE0 - RXLANE9) to the host. During operation, the module 200 can receive the 10 X 10G transmit data channels 210 for transmission as a single multiplexed data-carrying optical signal onto the optical fiber 260. While referred to as a "single multiplexed data carrying optical signal," those skilled in the art will recognize that the optical signal emitted onto the optical fiber 260 may include multiple wavelength channels, each channel carrying a portion of the 100G aggregate transmit data. In the present embodiment, four wavelength channels at a 25G per channel data rate carry the 100G aggregate transmit data. In other embodiments, however, five wavelength channels at a 20G per channel data rate could carry the 100G aggregate transmit data. Yet another approach is to use ten wavelength channels at a 10G per channel data rate.

The device 200 includes a plurality of serializers 202 and 204 which perform a variety of functions. In this example, there are two 5:2 serializers, at least one of which is a multi-mode serializer, described in more detail below. The serializers 202 and 204 receive the 10 X 10G data lanes from the host and generate 4 X 25G data lanes. In other words, each serializer receives five 10G data lanes and generates two re-clocked 25G lanes. Each serializer 202, 204 may be implemented individually on separate ICs, as shown in Figure 2. Alternately or additionally, both serializers 202, 204 can be combined into a single IC. Alternately or additionally, one or both of the serializers 202, 204 can be combined into a single IC with one or more deserializers or other components.

Returning to Figure 2, after the ten electrical signals 210 have been serialized into four 25G electrical signals, the four electrical signals are provided to four modulation drivers 206, 208, 212 and 214, which drive four electro-optical transducers 216, 218, 222 and 224 to emit four optical signals representative of the information carried in the four 25G electrical signals. Each of the four electro-optical transducers comprises a light source having any suitable configuration, including, but not limited to, a distributed feedback ("DFB") laser, a vertical cavity surface emitting laser ("VCSEL"), a cooled or uncooled externally modulated laser ("EML"), an EML with a wavelocker, a Fabry-Perot laser, a light emitting diode ("LED"), and the like. In the present embodiment, the four electro-optical transducers 216, 218, 222 and 224 comprise four EMLs packaged as a single component, although other arrangements, light sources and materials may also be used.

Because the present embodiment implements WDM, the four optical signals emitted by the transducers 216, 218, 222 and 224 each occupy a distinct wavelength channel. In one embodiment, the wavelengths may be chosen from the 200 GHz dense WDM ("DWDM") grid specified by Recommendation G.694.1 of the International Telecommunication Union Telecommunication Standardization Sector ("ITU-T"), and the transducers 216, 218, 222 and 224 are configured to emit optical signals at the chosen wavelengths. The electro-optical transducers 216, 218, 222 and 224 are coupled to a DWDM MUX 226 and the four 25G optical signals emitted by the transducers 216, 218, 222 and 224 are optically multiplexed into a single 100G multiplexed optical signal and transmitted over the optical fiber 260. Those skilled in the art will recognize that other configurations may be implemented. For instance, the electro-optical transducers may comprise an array of cooled or un-cooled DMLs configured to emit optical signals chosen from the 20 nm coarse WDM ("CWDM") grid specified by ITU-T G.694.2. In this case, the DML array would be coupled to a CWDM MUX and the optical channels would also be multiplexed and transmitted over optical fiber 260.

The multi-channel optoelectronic device 200 is also configured to receive a single 100G optically multiplexed signal from the optical fiber 270. A received optically multiplexed signal passes through an optical DEMUX 228 which performs the inverse of the MUX 226. In the present embodiment, the DEMUX comprises a 1:4 optical DEMUX, which means a 100G multiplexed optical signal passing through the DEMUX 228 is separated into four individual 25G optical signals, each of the four signals occupying a distinct wavelength channel.

The four 25G optical signals received from the DEMUX 228 are provided to four opto-electrical transducers 232, 234, 236 and 238 which transform the 25G optical signals into 25G electrical signals. Each of the opto-electrical transducers 232, 234, 236 and 238 comprises a photodetector such as a photodiode, an avalanche photodiode (APD), a positive-intrinsic-negative photodiode (PIN), and the like. In the present embodiment, the four opto-electrical transducers 232, 234, 236 and 238 comprise an array of four PINs fabricated on a single piece of Indium Phosphide, although other arrangements, transducers and materials may also be used.

The four 25G electrical signals produced by the opto-electrical transducers 232, 234, 236 and 238 are provided to four post-amplifiers 242, 244, 246 and 248 which amplify each 25G electrical signal. The four amplified 25G electrical signals are provided to two deserializers 252 and 254, each deserializer 252 and 254 receiving two amplified 25G electrical signals and generating five re-clocked 10G electrical signals. The resulting 10 X 10G data lanes 220 are provided to the host. As with the serializers 202, 204, each deserializer 252, 254 may be implemented individually on separate ICs, as shown in Figure 2. Alternately or additionally, both deserializers 252, 254 can be combined into a single IC. Alternately or additionally, one or both of the deserializers 252, 254 can be combined into a single IC with one or more serializers 202, 204, and/or other components.

Finally, the module 200 may also include a micro-controller 250. The micro-controller 250 may be used in a number of ways, including optimizing the dynamically varying performance of the optoelectronic device 200 by, for instance, adjusting settings on each of the drivers 206, 208, 212 and 214 and/or post-amplifiers 242, 244, 246 and 248. Various interfaces, such as an I²C interface 256 and hardware I/O 258 may permit the micro-controller to communicate directly with a host and/or hardware components within the optoelectronic device 200.

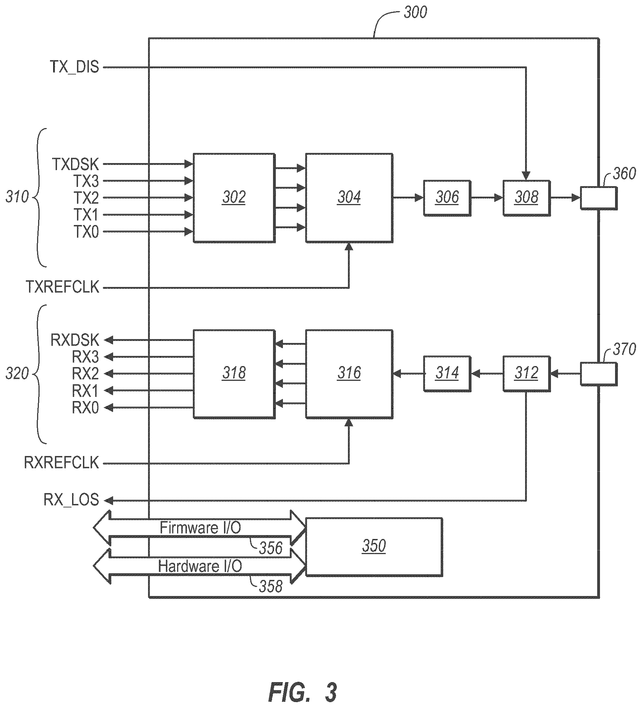

Figure 3 illustrates an example single-channel optoelectronic device 300 in which embodiments of a multi-mode SerDes IC may be implemented. The device 300 can achieve an aggregate bidirectional data rate of 40G by converting 5 X 10G transmit channels 310 (including 4 data lanes and a fifth deskew lane) from a host into a single 40G transmit optical signal and providing 5 X 10G receive data channels 320 (including four data lanes and a fifth deskew lane) to the host from a single 40G receive optical signal. The device 300 may be referred to as a 40G client or VSR optoelectronic device or a 40G application.

In this example, the 5 X 10G transmit channels are received by an SFI5.2 receiver 302 complying with the SFI5.2 interface standard. The SFI5.2 receiver 302 uses data from the fifth deskew lane to properly byte align the four data channels and convert between the 5 X 10G receive data channels 310 to four receive channels which are provided to a serializer 304. In one embodiment, the SFI5.2 receiver 302 and serializer 304 may correspond to the serializer 202 of Figure 2. Similar to the serializers 202 and 204 of Figure 2, the serializer 304 receives multiple data lanes at a relatively slow data rate and generates a fewer number of data lanes at a relatively fast data rate. In this example, the serializer 304 receives four 10G data lanes from the SFI5.2 receiver 302 and generates a single re-clocked 40G data lane. Of course, other transmission rates may also be achieved including by way of example and not limitation, 100G.

The single 40G serialized electrical signal is provided to a modulation driver 306 which drives an electro-optical transducer 308 to emit a 40G transmit optical signal representative of the information carried on the 40G serialized signal. In the present embodiment, the electro-optical transducer 308 may include an EML or other type of laser or light emitter. The 40G transmit optical signal may be emitted onto optical fiber 360 or other type of fiber.

The single-channel device 300 is also configured to receive a 40G receive optical signal from optical fiber 370. The 40G receive optical signal is provided to an opto-electrical transducer 312 which transforms the 40G receive optical signal into a 40G electrical data lane. A post amplifier 314 amplifies the 40G electrical data lane from the transducer 312 and provides an amplified 40G data lane to a deserializer 316.

Similar to the deserializers 252 and 254 of Figure 2, the deserializer 316 receives one or more data lanes at a fast data rate and generates a greater number of data lanes at a slow data rate. In particular, the deserializer 316 receives a single 40G data lane from the post amplifier 314 and generates four re-clocked 10G data lanes. The four re-clocked 10G data lanes are provided to an SFI5.2 transmit block 318 complying with the SFI5.2 interface standard. The SFI5.2 transmit block may perform encoding on the 4 X 10G channels and provide five 10G receive data channels 320 (four data channels plus a fifth deskew channel) to the host. In one embodiment, the deserializer 316 and SFI5.2 transmit block 318 correspond to the deserializer 252 of Figure 2.

The module 300 may additionally include a microcontroller 350 with an I²C or other host interface 356 and hardware I/O 358.

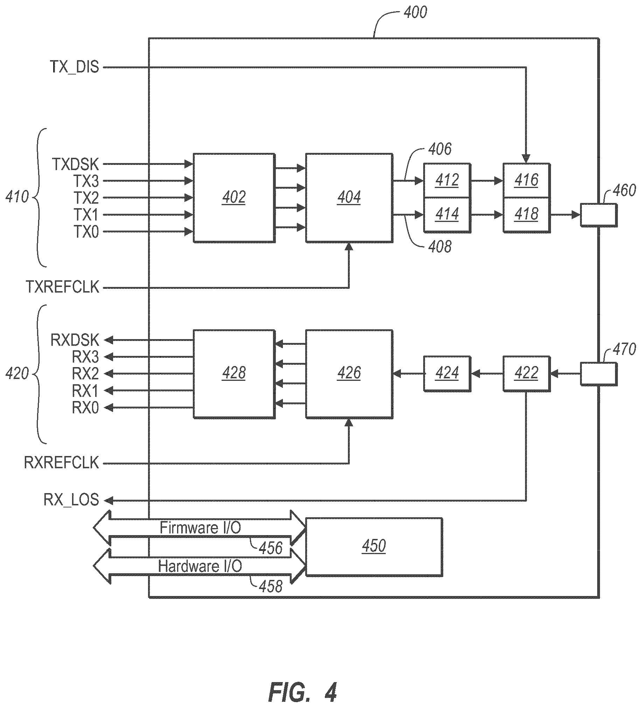

Figure 4 illustrates a second example single-channel optoelectronic device 400 in which embodiments of a multi-mode SerDes IC may be implemented. The device 400 is similar to the device 300 except that it can achieve an aggregate bidirectional data rate of 43G by receiving 5 X 10.75G transmit channels 410 (including 4 data lanes and a fifth deskew lane) from a host and providing 5 X 10.75G receive data channels 420 (including four data lanes and a fifth deskew lane) to the host. The device 400 may be referred to as a 43G transport application and may implement a differential phase shift keying ("DPSK") modulation format to optically transmit data.

The device 400 includes a receiver 402 similar to the receiver 302 of Figure 3 which receives the 5 X 10.75G transmit channels 410 from the host and uses data on a deskew lane to properly byte align four data channels and convert between the 5 X 10.75G transmit data channels 410 to four transmit channels which are provided to a serializer 404. The serializer 404 receives four 10.75G data lanes from the SFI5.2 receiver 402 and generates a re-clocked 43G data lane 406 and a 21.5 GHz clock 408 which is used in a later stage of modulation. Similar to Figure 3, the receiver 402 and serializer 404 may correspond in one embodiment to the serializer 202 of Figure 2

The 43G signal 406 and the 21.5 GHz clock are provided to two drivers 412 and 414 which drive two Mach-Zehnder modulated lasers ("MZMLs") to emit a single 43G optical signal representative of the data carried on the 43G electrical signal 406 onto the optical fiber 460.

The device 400 can also receive a 43G optical signal using a similar architecture as the device 300 of Figure 3. The device 400 receives a 43G optical signal from the optical fiber 470 and converts it to a 43G electrical signal with an opto-electrical transducer 422. The 43G electrical signal is amplified by a post-amplifier 424, which may include a transimpedance amplifier and/or a limiting amplifier in one embodiment. An amplified 43G signal is provided to a deserializer 426 which generates four re-clocked 10.75G lanes. The four re-clocked 10.75G lanes are provided to an SFI5.2 transmit block 428 which may perform encoding and convert the four 10.75G lanes to five 10.75G lanes which are provided to the host. Similar to Figure 3, the deserializer 426 and SFI5.2 transmit block 428 may correspond in one embodiment to the deserializer 252 of Figure 2.

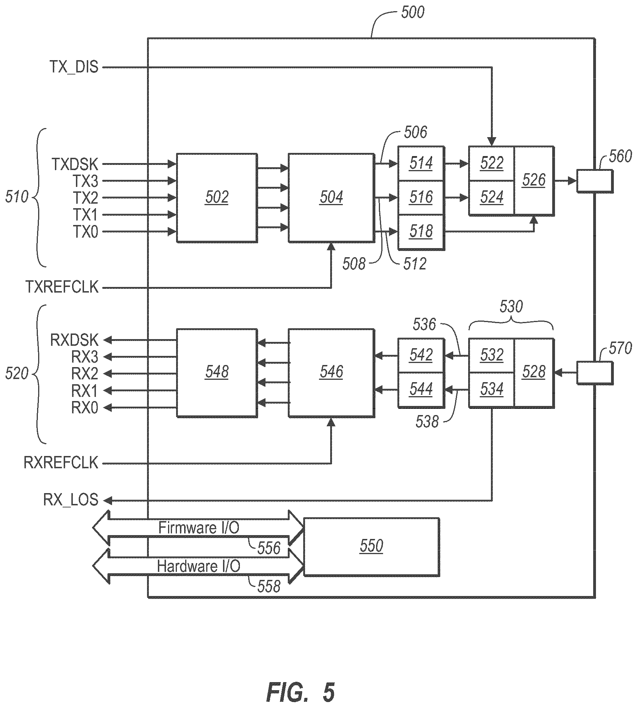

Figure 5 illustrates a third example single-channel optoelectronic device 500 in which embodiments of a multi-mode SerDes IC may be implemented. The device 500 may implement a differential quadrature phase shift keying ("DQPSK") modulation format and may be referred to as a 43G DQPSK optoelectronic device or application. The device 500 is similar to the device 400 of Figure 4 in both its 43G optical data rate and electrical interface with a host.

In particular, an SFI5.2 receiver 502 converts 5 X 10.75G transmit channels into 4 X 10.75G transmit channels which are provided to a serializer 504. Ultimately, the device 500 emits a single 43G optical signal on an optical fiber 560, the 43G optical signal being representative of the data received from the host. Similarly, the device 500 can receive a 43G optical signal from an optical fiber 570 which is ultimately split into 4 X 10.75G receive channels by a deserializer 546 and converted by an SFI5.2 transmitter 548 into 5 X 10.75G receive channels 520 which are provided to the host. The receiver 502 and serializer 504 may correspond in one embodiment to the serializer 202 of Figure 2. The deserializer 546 and transmitter 548 may correspond in one embodiment to the deserializer 252 of Figure 2.

Returning to Figure 5, the four 10.75G transmit channels received by the serializer 504 are used to generate two 21.5G transmit channels 506 and 508 and a 21.5 GHz clock 512. The two 21.5G channels 506 and 508 and the 21.5G clock 512 are used by three modulation drivers 514, 516 and 518 to drive two MZMLs 522 and 524 and a modelocked laser ("ML") 526 to emit a single 43G optical signal onto the optical fiber 560.

On the receive side, a single 43G optical signal is received from the optical fiber 570 by a receive block 530 including a Mach-Zehnder delay interferometer ("MZDI") 528 and two photodetectors 532 and 534. The receive block 530 generates two 21.5G electrical signals 536 and 538 which are provided to two post-amplifiers 542 and 544, each post-amplifier including in some embodiments a transimpedance amplifier and/or a limiting amplifier. The post-amplifiers 542 and 544 provide two amplified 21.5G data channels to the deserializer 546, which uses the two 21.5G data channels to generate four re-clocked 10.75G data channels, which are provided to the SFI5.2 transmitter 548 and processed as previously described.

### III. Multi-Mode Serializer

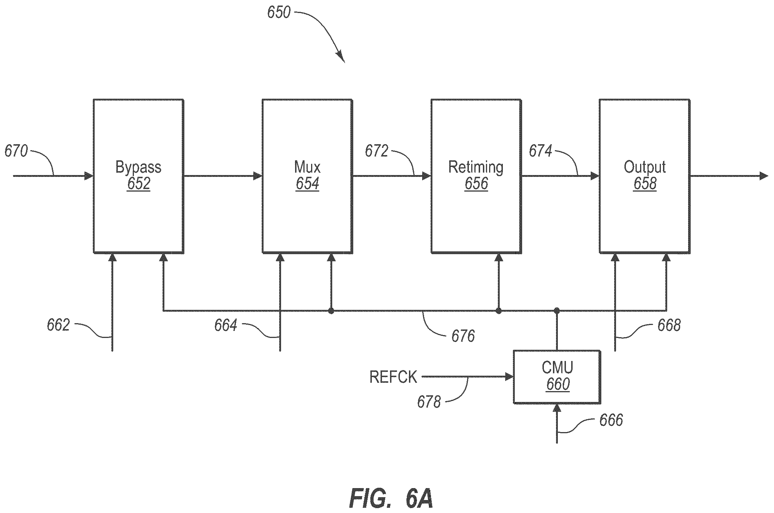

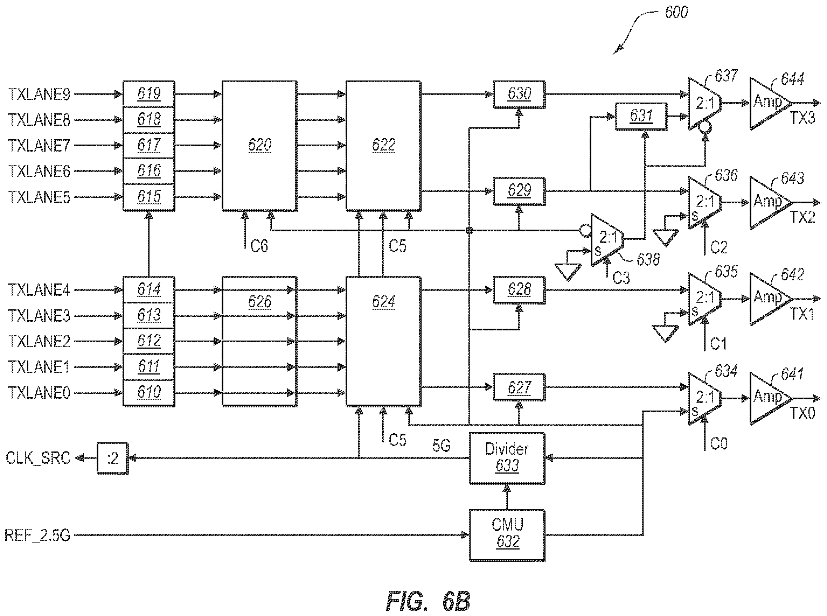

Now with regard to Figures 6A and 6B, a multi-mode serializer 650, 600 is described which may be implemented in the device architectures 200, 300, 400 and 500 of Figures 2-5. Specifically, the multi-mode serializer 650, 600 may correspond to one or more of the serializers 202 and 204 of Figure 2, the SFI5.2 receiver 302 and serializer 304 of Figure 3, the SFI5.2 receiver 402 and serializer 404 of Figure 4 and the SFI5.2 receiver 502 and serializer 504 of Figure 5. As will be described, the multi-mode serializer may operate in at least two of 100G mode (e.g., in a 100GE application), 40G VSR mode, 43G transport mode and 43G DQPSK mode or other modes.

In particular, Figure 6A illustrates a simplified block view of one embodiment of a multi-mode serializer 650. The multi-mode serializer 650 is designed to accept any number of transmit signals with many different aggregate data rates, so that it may be used in the architectures 200, 300, 400 and 500 already described as well as in other architectures. Accordingly, the multi-mode serializer 650 includes a bypass stage 652 for accepting a plurality of transmit signals, a multiplexing stage 654, a retiming stage 656, an output stage 658 and a clock multiplier unit (CMU) 660. Some of these components perform different functions depending, for instance, on the aggregate data rate of the transmit signals and the particular application in which the multi-mode serializer 650 is implemented. Mode-selection signals 662, 664, 666 and 668 may be provided by, for example, a micro-controller to instruct each component what function to perform.

In the present example, the bypass stage 662 can accept a plurality of transmit signals 670 and either pass the transmit signals 670 directly through to the multiplexer stage 654 or decode the transmit signals. When the aggregate data rate of the transmit signals is 100G as in Figure 2, the bypass stage 652 can pass 10 X 10G transmit signals directly through to the multiplexer stage 654, which may perform a 10:4 multiplex operation to generate 4 X 25G multiplexed signals 672 from the 10 X 10G transmit signals 670. Alternately, when the aggregate data rate of the transmit signals is 40G or 43G, the bypass stage 652 can decode 5 X 10G (or 10.75G) transmit signals 670 into 4 X 10G (or 10.75G) transmit signals before providing the four transmit signals to the multiplexer stage 654, which may perform a 4:2 multiplex operation to generate 2 X 20G (or 21.5G) multiplexed signals 672.

The multiplexed signals 672 can be clocked out of the multiplexer stage 654 into the retiming stage 656, which then provides retimed multiplexed signals 674 to the output stage 658. A high speed clock signal 676 may be generated by the CMU 660 for processing the transmit signals (e.g., clocking signals in and out of a stage), and may be based on a reference clock signal 678. The CMU 660 generates a high-speed clock signal by multiplying up the reference clock signal. The multiplication operation performed by the CMU may depend on the aggregate data rate of the transmit signals. In the present example, a 2.5 GHz reference clock is multiplied in the CMU 660 by ten to obtain a 25 GHz high-speed clock when the aggregate data rate of the transmit signals is 100G. However, when the aggregate data rate of the transmit signals is 40G, the CMU 660 may multiply the 2.5 GHz reference clock by eight to obtain a 20GHz high-speed clock.

The retimed multiplexed signals 674 are then provided to the output stage 658, which can provide the retimed multiplexed signals to transmit optics (not shown) within an optoelectronic device. As with the bypass stage 652, the multiplexing stage 654, and the CMU 660, the function performed by the output stage 658 may depend on the aggregate data rate of the transmit signals. When the aggregate data rate is 100G or 43G DQPSK, the retimed multiplexed signals 674 may pass through the output stage 658 unchanged and be provided to the transmit optics. For 40G and 43G transport data rates, the retimed multiplexed signals 674 may be multiplexed into a single serial signal before being provided to the transmit optics. Additionally, for 43G transport and 43G DQPSK data rates, a 21.5 GHz clock signal generated by the CMU 660 may additionally be provided by the output stage 658 to the transmit optics. To accomplish these different functions, the output stage can include a final dynamic high-speed multiplexer and a plurality of path selectors, such as static multiplexers, as will be described more fully with respect to Figure 6B.

The multi-mode serializer 650 of Figure 6A can be implemented in a single IC. Alternately or additionally, it can be separated across multiple ICs. When combined in a single IC, it may correspond to an IC that includes both of serializers 202 and 204 of Figure 2. When separated across multiple ICs, it may correspond to two ICs, one that includes serializer 202 and another that includes serializer 204, with each of the separate ICs including its own CMU.

Turning now to Figure 6B, a specific embodiment 600 of the example multi-mode serializer 650 of Figure 6A is schematically illustrated. The multi-mode serializer 600 includes a plurality of input nodes 610-619 for receiving input data channels from the host. Each node may be configured to receive a single channel. For instance, in 100G mode, all ten input nodes 610-619 receive a 10G signal, while in 40G VSR, 43G transport and 43G DQPSK modes, only input nodes 615-619 receive a 10G or 10.75G signal. Each input node 610-619 may also include a delay lock loop ("DLL") and/or a clock and data recovery circuit ("CDR") for recovering the input data lanes.

The output of input nodes 615-619 is coupled to a dual-mode bypass block 620 and the output of the dual-mode bypass block is coupled to a main multiplexing block 622. Note that, as used herein, "coupled to" is defined to mean both a direct connection between two or more circuit objects without any intervening circuit objects and an indirect connection between two or more circuit objects with one or more intervening circuit objects. For example, two circuit objects directly connected to each other are "coupled to" one another. The same two circuit objects would also be "coupled to" each other if there were one or more intervening circuit objects connected between them.

When operating in 100G mode, the dual-mode bypass block 620 allows the data lanes from input nodes 615-619 to pass straight through to the main multiplexing block 622. However, in 40G VSR, 43G transport and/or 43G DQPSK, the dual-mode bypass block 620 operates as an SFI5.2 receiver. In other words, 5 X 10G (or 5 X 10.75G) data lanes are decoded by the dual-mode bypass block 622 into 4 X 10G (or 4 X 10.75G) data lanes which are provided to the main multiplexing block 622.

The output of input nodes 610-614 is coupled to the input of a second main multiplexing block 624. There may optionally be a bypass block 626 coupled to the output of the input nodes 610-614 and the input of the second main multiplexing block 624. However, the purpose of the bypass block 626 is to allow the data lanes from the input nodes 610-614 to pass straight through to the second main multiplexing block 624, and as such need not be included. The input nodes 610-614 each receive a data lane when operating in 100G mode and are unused when operating in the 40G and 43G modes.

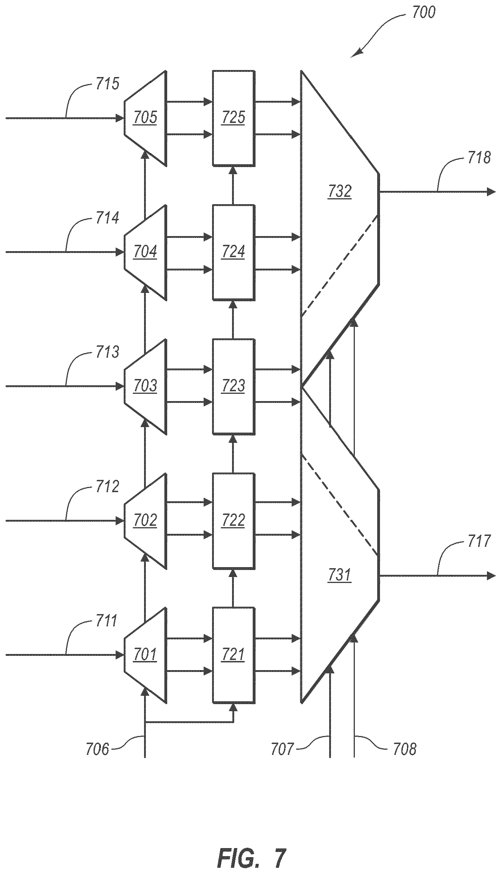

The main multiplexing block 622 is a dual-mode main multiplexing block, the structure of which will be described more fully with respect to Figure 7. In the present embodiment, the dual-mode multiplexer 622 may perform a 5:2 or a 4:2 mux function depending on its mode of operation. When operating in 100G mode, the dual-mode main multiplexing block 622 performs a 5:2 mux on the five data lanes received from the input nodes 615-619, generating two re-clocked 25G data lanes from five 10G data lanes. However, when operating in 40G or 43G modes, the dual-mode multiplexer 622 receives four 10G (or 10.75G) data lanes from the SFI5.2 receiver 620 and performs a 4:2 mux function thereon to generate two re-clocked 20G (or 21.5G) data lanes.

The main multiplexing block 624 may be a dual-mode multiplexing block similar to the dual-mode multiplexer 622. However, the block 624 may also be a single-mode 5:2 multiplexing block for generating two re-clocked 25G data lanes from the 5 X 10G data lanes received at input nodes 610-614. Using a dual-mode multiplexer for main block 624 may enable certain test features which may be desirable for improving performance, although it is not required since the main block 624 only performs a 5:2 mux function during normal operation.

When operating in 100G mode, the four 25G signals generated by the main multiplexing blocks 622 and 624 are clocked out of the multiplexing blocks using four final flip flops 627-630. When operating in the 40G or 43G modes, the two 20G or 21.5G signals generated by the main multiplexing block 622 are clocked out of the multiplexing block 622 using two final flip flops 629 and 630. In the 100G case, a 25GHz clock supplied by a common CMU 632 is shared by all four final flip flops 627-630. In the 40G and 43G cases, a 20GHz or 21.5GHz clock is supplied by the CMU 632 and shared by the two final flip flops 629 and 630.

The CMU 632 takes a lower clock reference, for example a 622 MHz or 2.5 GHz clock, and multiplies it up in frequency using a phase-locked loop ("PLL") to achieve the desired frequency (e.g., 20 GHz, 21.5 GHz or 25 GHz). When using a 2.5 GHz reference clock, the CMU 632 multiplies by ten for 100G mode or by 8 for 40G mode. A slight extension of the frequency range may be implemented, for instance, by an additional CMU oscillation section in order to obtain the 21.5 GHz clock required for the 43G modes. There may also be a programmable divider 633 coupled to the CMU 632 used to provide divided versions of the clock signal generated by the CMU 632 to flip flops within the main multiplexing blocks 622 and 624 and to the input nodes 610-619. Advantageously, the CMU 632 is shared by both of the main multiplexing blocks 622 and 624, thereby reducing the cost and footprint of the multi-mode serializer 600.

Coupled to the outputs of the four final retiming flip flops 627-630 are four 2:1 multiplexers 634-637. The first three multiplexers 634-636 are static multiplexers, meaning they act only as path selectors. The fourth multiplexer 637 is a final dynamic high-speed multiplexer. Four output driver amps 641-644 are coupled to the output of the four multiplexers 634-637. In 100G mode, the four 25G data lanes clocked into each of the final high speed flips flops 627-630 are used directly by the output driver amps 641-644 and provided to transmitter optics (e.g., modulation drivers, electro-optical transducers), which are not shown in Figure 6B. This architecture is known as full-rate architecture.

In 40G VSR (or 43G transport) mode, two 20G (or 21.5G) data lanes are clocked into the final flip flops 629 and 630. The path selector 636 directs data from the final flip flop 629 to a fifth final flip flop 631. The 20G (or 21.5G) data lanes from the final flip flops 630 and 631 are multiplexed into a single 40G (or 43G) signal by the final dynamic high speed multiplexer 637. A 20 GHz (or 21.5 GHz) clock can be provided to the final flip flop 631 via a fifth path selector 638. The 20 GHz (or 21.5 GHz) clock can also be used to switch the dynamic multiplexer 637 to provide the 40G (or 43G) output data lane. This is known as half-rate architecture. The 40G (or 43.5G) output from the final dynamic multiplexer 637 is provided to the output driver 644, which provides a 40G (or 43.5G) signal to the transmitter optics (not shown).

The final dynamic multiplexer 637 and driver amp 644 are designed to have up to 43G bandwidth to enable the 40G VSR and 43G transport modes, which is more than required for 100G mode where only 25G bandwidth is needed and 43G DQPSK mode where only 21.5G bandwidth is needed. As such, an additional control can be added to reduce the output bandwidth (and power) of the final multiplexer 637 and driver amp 644 when the multi-mode serializer 600 is operating in 100G or 43G DQPSK modes. This may be accomplished, for example, by reducing the bias currents of the multiplexer 637 and driver amp 644.

In 43G DQPSK mode, two 21.5G data lanes are clocked into the final flip flops 629 and 630. The path selector 636 permits the 21.5G data lane from the final flip flop 629 to pass directly through to the output driver 643. Similarly, the 21.5G data lane from the final flip flop 630 passes directly through to the output driver 644. In this manner, two 21.5G data lanes are provided to the transmitter optics from the output drivers 643 and 644.

In both 43G transport and 43G DQPSK modes, the path selector 634 selects a 21.5 GHz clock signal from the CMU 632 and provides it to the driver amp 641, which provides the 21.5 GHz clock to the transmitter optics.

The use of the half-rate architecture for the 40G and 43G modes allows the CMU 632 to be optimized for 100G (i.e., 20G or 25G per channel) operation. As an alternative, the 40G or 43G architecture can be full-rate, which would require that the CMU be operated at twice the required rate for 100G mode. This is easily accommodated by a simple divide by 2 circuit after the CMU to obtain the proper clock signal for timing the final output flip-flops in the multiplexers 622 and 624. In this case, the path including the final 2:1 multiplexer 637 would be slightly different. A full-rate 40G or 43G architecture may have performance advantages. Further, a full-rate CMU may potentially use less silicon area, since frequency-dependant components (like inductors in the CMU) may be smaller.

In summary, then, operation in 100G mode is characterized by the following. Ten by 10G data lanes are received by ten input nodes 610-619. All ten data lanes are recovered by the input nodes 610-619 and provided to two main multiplexing blocks 622 and 624. Each of the main multiplexing blocks 622 and 624 performs a 5:2 multiplexing function on 5 X 10G data lanes to generate two 25G data lanes, or 4 X 25G data lanes total. The 4 X 25G data lanes are clocked out of the main multiplexing blocks with four final flip flops 627-630 and then used directly by four output driver amps 641-644 which provide the 4 X 25G data lanes to the transmitter optics.

Operation in 40G VSR mode (and 43G transport mode) is characterized by the following. Five by 10G (or 10.75G) data lanes are received by five input nodes 615-619. All five data lanes are recovered by the input nodes and provided to a dual-mode bypass block 620 which acts as an SFI5.2 receiver to decode the 5 X 10G (or 10.75G) data lanes into 4 X 10G (or 10.75G) data lanes. The 4 X 10G (or 10.75G) data lanes are provided to the main multiplexing block 622 which performs a 4:2 multiplexing function to generate two re-clocked 20G (or 21.5G) data lanes. The 2 X 20G (or 21.5G) data lanes are clocked out of the main multiplexing block with two final flip flops 629 and 630. Using a path selector 636, the two data lanes are 2:1 multiplexed by the final dynamic high speed multiplexer 637 to generate a 40G (or 43G) signal.

Operation in 43G DQPSK mode is similar to operation in 40G VSR and 43G transport modes in some respects. Five by 10.75G data lanes are received by the input nodes and provided to the SFI5.2 receiver block 620 which decodes the five data lanes into 4 X 10.75G data lanes. The main multiplexing block generates 2 X 21.5G data lanes which are clocked into the final flip flops 629 and 630. Rather than multiplexing the 2 X 21.5G data lanes into a single 43G signal, however, both data lanes are provided to the output driver amps 643 and 644 and provided to the transmitter optics.

Operation in 43G transport and 43G DQPSK modes is additionally characterized by the path selector 634 selecting a 21.5 GHz clock from the CMU 632 and providing it to the output driver amp 641.

The multi-mode serializer 600 can be implemented as a single IC. Alternately or additionally, it can be separated across two or more ICs as illustrated by serializers 202, 204 in Figure 2 and implied by the two transmit paths (e.g., data lanes 610-614 and data lanes 615-619) of Figure 6B. For instance, a first IC corresponding to the serializer 202 of Figure 2 (and SFI 5.2 receivers 302, 402, 502 and serializers 304, 404, 504 of Figures 3-5) may include input nodes 615-619, dual-mode bypass block 620, dual-mode multiplexer 622, retiming flip flops 629-631, static multiplexers 636 and 638, dynamic multiplexer 637, and output driver amps 643 and 644. In this case, the first IC additionally includes a CMU 632 and divider 633.

A second IC corresponding to the serializer 204 of Figure 2 may include input nodes 610-614, optional bypass block 626, main multiplexing block 624, retiming flip flops 627, 628, static multiplexers 634, 635, output driver amps 641, 642, CMU 632, and divider 633. In this example, the main multiplexing block 624 can be a dual-mode multiplexing block or a single-mode multiplexing block.

In the embodiment just described, wherein the multi-mode serializer 600 is spread across two ICs, the first IC may be multi-mode while the second IC is single-mode. In particular, in 100G mode the first IC can receive and convert half (e.g., 5) of the 10 X 10G parallel data signals received from a host in a 100G application to two serial 25G signals. In this case, the aggregate data rate of the signals received by the first IC from the host is 50G since it only receives half of the parallel data signals. In one or more other modes, the first IC can receive and convert all (e.g., 5) of the 5 X 10G (or 5 X 10.75G) parallel data signals in a 40G VSR (or 43G transport or 43G DQPSK) application to one 40G serial signal (or one 43G signal plus 21.5 GHz clock, or two 21.5G serial signals plus 21.5GHz clock) as previously described. In this case, the aggregate data rate of the parallel signals received by the first IC is 40G (or 43G). Whereas the first IC is a multi-mode IC configured to process half of 10 X 10G parallel signals for 100G applications or all of 5 X 10G (or 5 X 10.75G) parallel signals for 40G VSR, 43G transport, and/or 43G DQPSK applications, the second IC can be a single-mode IC configured to process the remaining half of the 10 X 10G parallel signals for 100G applications.

With reference now to Figure 7, one embodiment of a dual-mode main multiplexing block 700 is illustrated which may be used in embodiments of the multi-mode serializer 600 depicted in Figure 6B. The dual-mode multiplexer 700 may correspond to the main multiplexing block 622 and/or 624 of Figure 6B.

The dual-mode multiplexer 700 includes a plurality of 2:1 input demultiplexers 701-705 for receiving and doubling a plurality of input data lanes 711-715. Coupled to the plurality of 2:1 input demultiplexers are a plurality of synchronizer flip flops 721-725 for clocking the doubled data lanes out of the input demultiplexers 701-705. The input demultiplexers 701-705 and synchronizer flip flops 721-725 use a divided down clock 706 supplied by the divider 633 of Figure 6B, which may be a 5 GHz clock for instance. Coupled to the plurality of synchronizer flip flops 721-725 are a plurality of output multiplexers 731 and 732. Each of the output multiplexers 731 and 732 generates a single data lane 733 and 734, respectively, from multiple input data lanes. A mode-selection signal 707 selects the 100G or 40G/43G modes for the output multiplexers 731 and 732. A clock signal 708 provided by the CMU 632 is used to clock the data out of the output multiplexers 731 and 732. The clock signal 708 may be a 20 GHz, 21.5 GHz or 25 GHz signal depending on the mode of operation.

In 100G mode, the dual-mode multiplexer 700 receives 5 X 10G data lanes 711-715 from the input nodes 615-619 of Figure 6B. The 5 X 10G data lanes are converted to 10 X 5G data lanes, synchronized and provided to two 5:1 output multiplexers 731 and 732 (5:1 output mode having been selected by the mode-selection signal 707). Using a 25 GHz clock signal 708, each output multiplexer 731 and 732 generates a 25G data lane 717 and 718. A second dual-mode multiplexer may similarly receive 5 X 10G data lanes from the input nodes 610-614 of Figure 6B and generate 2 X 25G data lanes.

In 40G VSR (and 43G transport or 43G DQPSK) mode, the dual-mode multiplexer 700 receives 4 X 10G (or 10.75G) data lanes 711, 712, 714 and 715 from the SFI receiver block 620 of Figure 6B. Note that the data lane 713 is unused. The 4 X 10G (or 10.75G) data lanes are converted to 8 X 5G (or 5.375G) data lanes, synchronized and provided to two 4:1 output multiplexers 731 and 732. Using a 20 GHz (or 21.5 GHz) clock signal 708, each output multiplexer 731 and 732 generates a 20G (or 21.5G) data lane 717 and 718.

### IV. Example Multi-Mode Deserializer

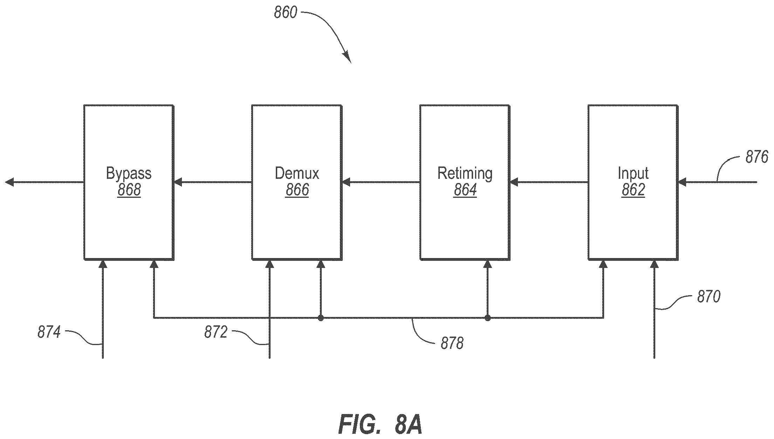

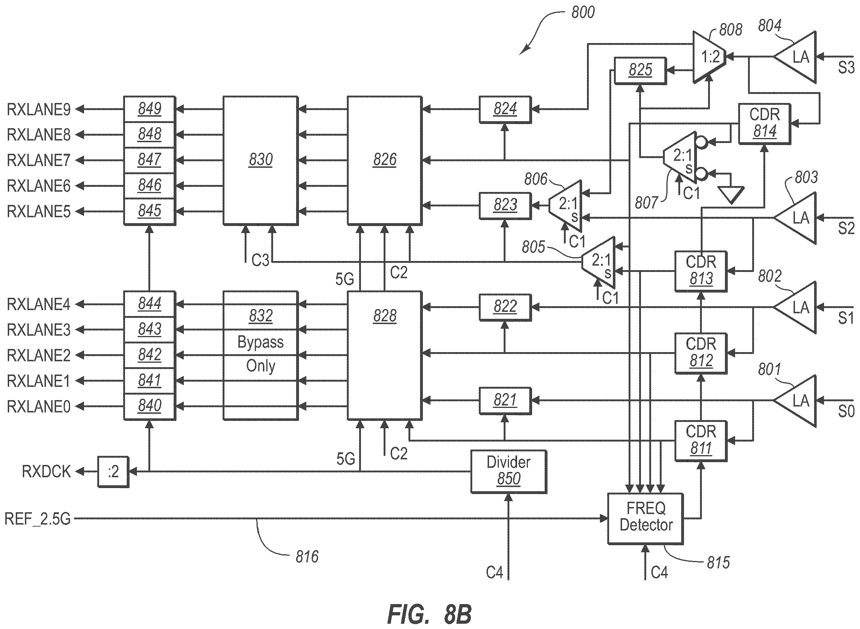

Now with regard to Figures 8A and 8B, a multi-mode deserializer is described which may be implemented in two or more of the device architectures 200, 300, 400 and 500 of Figures 2-5. Specifically, the multi-mode deserializer may correspond to the deserializers 252 and 254 of Figure 2, the SFI5.2 transmitter 318 and deserializer 316 of Figure 3, the SFI5.2 transmitter 428 and deserializer 426 of Figure 4 and the SFI5.2 transmitter 548 and deserializer 546 of Figure 5. As will be described, the multi-mode deserializer may operate in at least two of 100G mode (e.g., in a 100GE application), 40G VSR mode, 43G transport mode and 43G DQPSK mode.

In particular, Figure 8A illustrates a simplified block view of one embodiment of a multi-mode deserializer 860. The multi-mode deserializer 860 is designed to accept one or more receive signals at different data rates so that it may be used in the architectures 200, 300, 400 and 500 already described as well as in other architectures. Accordingly, the multi-mode deserializer 860 includes an input stage 862 for accepting one or more receive signals, a retiming stage 864, a demultiplexing stage 866 and a bypass stage 868. Some of these components perform different functions depending, for instance, on the number of accepted receive signals, or the aggregate data rate of the received signals. For this reason, mode selection signals 870, 872 and 874 may be provided by a micro-controller, in one embodiment, to instruct each component what function to perform.

In the present example, the input stage 862 can accept one or more receive signals 876. The one or more receive signals 876 may be provided by receiver optics in an optoelectronic device. According to one embodiment, the input stage 862 accepts only one receive signal at a 40G or 43G transport data rate and separates the one receive signal into two 20G or 21.5G signals. In another embodiment, the input stage may accept four 25G receive signals (100G aggregate data rate) or two 21.5G receive signals (43G DQPSK aggregate data rate) and pass the four 25G or two 21.5G receive signals directly through to the retiming stage 864. To accomplish these different functions, the input stage 862 can include an input dynamic high-speed demultiplexer and a plurality of path selectors, such as static demultiplexers, as will be described more fully with respect to Figure 8B. The input stage 862 may also include one or more clock and data recovery blocks for recovering a clock from the one or more receive signals. The recovered clock 878 and divided versions thereof may be provided to the components 864, 866 and 868 for processing the signals accepted/generated at the input stage 862.

Signals generated in the input stage 862 are provided to the retiming stage 864, which then provides retimed signals to the demultiplexer stage 866. The demultiplexer stage may separate the retimed signals into different numbers of separated signals depending on the aggregate data rate of the retimed signals received from the input stage and then provide the separated signals to the bypass block 868. The operation of the bypass block may similarly depend on the aggregate data rate of the retimed signals, passing the separated signals directly through as output or encoding the separated signals. For instance, when the aggregate data rate is 40G or 43G, the demultiplexer stage 866 separates two retimed signals into four separated signals and provides them to the bypass block. The bypass block 868 encodes the data prior to providing encoded data as output. When the aggregate data rate is 100G, however, the demultiplexer stage 866 separates four retimed signals into ten separated signals and the bypass block 868 passes the ten separated signals as output.

The multi-mode deserializer 860 of Figure 8A can be implemented in a single IC. Alternately or additionally, it can be separated across multiple ICs. When combined in a single IC, it may correspond to an IC that includes both of deserializers 252 and 254 of Figure 2. When separated across multiple ICs, it may correspond to two ICs, one that includes deserializer 252 and another that includes deserializer 254.

Turning now to Figure 8B, a specific embodiment 800 of the example multi-mode deserializer is schematically illustrated. The multi-mode deserializer 800 includes a plurality of input nodes for receiving one or more high speed serial signals from a post-amplifier, for example. Each input node is designed to receive a single data lane. Each input node may include a limiting amplifier and a CDR. For instance, a plurality of limiting amplifiers 801-804 are provided for receiving one or more data lanes from receiver optics in an optoelectronic device. A plurality of CDRs 811-814 are coupled to the outputs of the limiting amplifiers 801-804 for recovering a clock on the one or more received data lanes. In 100G mode, each of four input nodes, including a limiting amplifier 801-804 and a CDR 811-814, receives a 25G signal and recovers a 25 GHz clock for each signal. In 40G VSR and 43G transport modes only one input node, including limiting amplifier 804 and CDR 814, receives a 40G (or 43G) signal and recovers a 20 GHz or 21.5 GHz clock signal. In 43G DQPSK mode, two input nodes, including limiting amplifiers 803 and 804 and CDRs 813 and 814, each receive a 21.5G data lane and recover a 21.5 GHz clock.

In the present embodiment, a single frequency detector 815 is shared by all of the CDRs 811-814 irrespective of the mode of operation, saving the cost of multiple frequency detector blocks for each received data lane. Hence, in 100G or 43G DQPSK modes, an input multiplexer in the frequency detector 815 can cycle through each of the four individual 25 GHz clocks in 100G mode or each of the two individual 21.5 GHz clocks in 43G DQPSK mode to sequentially perform a frequency detection function. The CDRs 811-814 can be set to a frequency acquisition mode individually or as a group when an out of frequency lock condition is detected.

In one embodiment of the invention, the frequency detector 815 may receive a 2.5 GHz reference clock 816 for performing its frequency detection function. In this case, the frequency detector 815 may perform a divide by 10 operation on the four individual 25GHz clocks while in 100G mode, or a divide by 8 operation on one or more individual 20GHz or 21.5GHz clocks while in 40G VSR, 43G transport or 43G DQPSK modes.

In addition to being coupled to the plurality of CDRs 811-814, the outputs of the limiting amplifiers 801-804 are coupled to a plurality of initial retiming flip flops 821-824 for clocking one or more high speed serial data lanes into a plurality of main demultiplexing blocks 826 and 828. However, a number of other components may be disposed between the limiting amplifiers 801-804, the initial retiming flip flops 821-824 and the CDRs 811-14. For instance, three static multiplexers or path selectors 805-807, an input dynamic high speed demultiplexer 808 and a fifth initial retiming flip flop 825 are provided.

During operation in 40G VSR and 43G transport modes, the clock signal (20 GHz or 21.5 GHz) generated by the CDR 814 may be provided via the path selector 807 to the fifth initial retiming flip flop 825 and the input dynamic demultiplexer 808, to the initial retiming flip flop 824 and the main demultiplexing block 826, and via the path selector 805 to the main demultiplexing block 826 and a dual-mode bypass block 830. The 20 GHz or 21.5 GHz clock signal and a 40G or 43G data lane from limiting amplifier 804 are used by the dynamic demultiplexer 808 to generate two 20G or 21.5G data lanes, one of which is clocked into the initial flip flop 824, and the other of which is clocked into the initial flip flop 825. The path selector 806 provides the 20G or 21.5G data lane from flip flop 825 to flip flop 823. Both 20G or 21.5G data lanes are clocked into the main demultiplexing block 826.

During operation in 100G and 43G DQPSK modes, the clock signal (25 GHz or 21.5 GHz) generated by the CDR 814 may be provided to the initial retiming flip flop 824 and the main demultiplexing block 826 for clocking in data. The 25G or 21.5G input data lane from limiting amplifier 804 passes directly through the dynamic demultiplexer 808 to the initial retiming flip flop 824 and then to the main demultiplexing block 826. Similarly, the 25G or 21.5G input data lane from the limiting amplifier 803 passes through the path selector 806 to the initial retiming flip flop 823 and then on to the main demultiplexing block 826. The 25 GHz or 21.5 GHz clock signal from the CDR 813 is provided through the path selector 805 to the main demultiplexing block 826 and the dual mode bypass block 830. In 43G DQPSK mode, the limiting amplifiers 801 and 802, CDRs 811 and 812 and main demultiplexing block 828 are unused. In 100G mode, however, the 25G input data lanes received by limiting amplifiers 801 and 802 are clocked into the initial retiming flip flops 821 and 822 and the main demultiplexing block with 25 GHz clock signals from CDRs 811 and 812, respectively.

The input demultiplexer 808 and limiting amp 804 are designed to have up to 43G bandwidth to enable 40G VSR and 43G transport modes, which is more than required for 100G mode where only 25G bandwidth is needed and 43G DQPSK mode where only 21.5G bandwidth is needed. Just as with the final multiplexer 637 and driver amp 644 of Figure 6B, an additional control can be added to reduce the input bandwidth (and power) of the input demultiplexer 808 and limiting amp 804 when the multi-mode serializer 800 is operating in 100G or 43G DQPSK modes. For instance, this may be done by reducing the bias currents of the demultiplexer 808 and limiting amplifier 804.

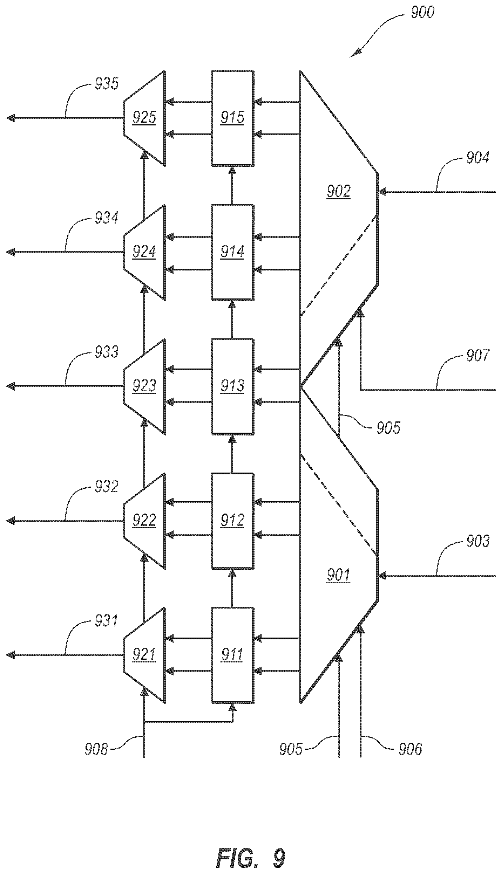

The outputs of initial retiming flip flops 821-824 are coupled to the main demultiplexing blocks 826 and 828. The main demultiplexing block 826 is a dual-mode main demultiplexing block, the structure of which will be described more fully with respect to Figure 9. In the present embodiment, the dual-mode demultiplexer 826 may perform a 2:5 or 2:4 demux function depending on its mode of operation. When operating in 100G mode, the dual-mode main multiplexing block 826 performs a 2:5 demux on the two data lanes received from the initial retiming flip flops 823 and 824, generating 5 X 10G data lanes from 2 X 25G data lanes. However, when operating in 40G or 43G modes, the dual-mode demultiplexer 826 receives two 20G or 21.5G data lanes and performs a 2:4 demux function thereon to generate four re-clocked 10G or 10.75G data lanes.

The main demultiplexing block 828 may be a dual-mode demultiplexing block similar to the dual-mode demultiplexer 826. However, the demultiplexer block 828 may also be a single-mode 2:5 demultiplexing block for generating five re-clocked 10G data lanes from the 2 X 25G data lanes received from initial retiming flip flops 821 and 822. Using a dual-mode demultiplexer for main block 828 may enable certain test features which may be desirable for improving performance, although it is not required since the main block 828 only performs a 2:5 demux function during normal operation.

The output of the main demultiplexing block 826 is coupled to the dual-mode bypass block 830 and the output of the main demultiplexing block 828 is coupled to the optional bypass block 832. The bypass blocks 830 and 832 are coupled to a plurality of output nodes 840-849, each of which may include a final retiming flip flop. When operating in 100G mode, the dual-mode bypass block 830 and bypass block 832 permit the 10 X 10G data lanes from main demultiplexing blocks 826 and 828 to pass straight through to the output nodes 840-849, the 10 X 10G data lanes then being provided to a host device for further processing.

In 40G VSR, 43G transport and/or 43G DQPSK modes, only 4 X 10G or 4 X 10.75G data lanes are provided from the dual-mode demultiplexer 826, none being provided by the main demultiplexer block 828. This has a number of implications. First, if the data lanes provided at the output nodes 840-849 are to comply with the SFI5.2 protocol, the dual-mode bypass block 830 operates as an SFI5.2 transmitter. In this case, 4 X 10G (or 10.75G) data lanes are encoded by the dual-mode bypass block 830 into 5 X 10G (or 10.75G) data lanes which are provided to the host device. Second, the bypass block 832 is unnecessary since the main demultiplexing block 828 is only used during operation in 100G mode. That is, the output of the main demultiplexing bock 832 could be coupled directly to the output nodes 840-844. Finally, the output nodes 840-844 only provide data lanes to a host during operation in 100G mode.

Similar to the Serializer 600 of Figure 6, the Deserializer 800 of Figure 8 implements a full-rate architecture for 100G mode and a half-rate architecture for 40G and 43G modes. One skilled in the art will recognize that the use of the half-rate architecture for the 40G and 43G modes allows the CDR 814 to be optimized for 100G (i.e., 20G or 25G per channel) operation. As an alternative, the 40G or 43G architecture can be full-rate, which would require that the CDR be operated at twice the required rate for 100G mode. This is easily accommodated by a simple divide by 2 circuit after the CDR to obtain the proper clock signal for timing the input flip-flops in the demultiplexers 826 and 828. Obviously, the path including the input 1:2 demultiplexer 808 would be slightly different. A full-rate 40G or 43G architecture may have performance advantages. Further, a full-rate CDR may potentially use less silicon area, since frequency-dependant components may be smaller.

In summary, then, operation in 100G mode is characterized by the following. Four by 25G serial data lanes are received by four input nodes, each input node including a limiting amplifier 801-804 and a dedicated CDR 811-814. A 25 GHz clock signal is recovered for each serial data lane and used to clock the four 25G signals into two main demultiplexing blocks 826 and 828. Each of the main demultiplexing blocks 826 and 828 performs a 2:5 demultiplexing function on 2 X 25G data lanes to generate five 10G data lanes, or 10 X 10G data lanes total. The 10 X 10G data lanes are clocked out of the main demultiplexing blocks into 10 output nodes 840-849 and then provided for further processing.

Operation in 40G VSR mode (and 43G transport mode) is characterized by the following. One 40G (or 43G) serial data lane is received by an input node, the input node including a limiting amplifier 804 and a CDR 814. The CDR recovers a 20 GHz (or 21.5 GHz) clock signal from the serial data lane which is used by an initial retiming flip flop 808 and an input dynamic high speed demultiplexer 808 to generate two 20G (or 21.5G) data lanes from the 40G (or 43G) serial data lane. The two 20G (or 21.5G) data lanes are clocked into a dual-mode demultiplexing block 826 which performs a 2:4 demultiplexing function on 2 X 20G (or 21.5G) data lanes to generate four 10G (or 10.75G) data lanes. The 4 X 10G (or 10.75G) parallel data lanes are provided to a dual-mode bypass block 620 which acts as an SFI5.2 transmitter to encode the 4 X 10G (or 10.75G) data lanes into 5 X 10G (or 10.75G) data lanes. The 5 X 10G (or 10.75G) data lanes are clocked out of the multi-mode deserializer 800 using five output nodes 845-849 and subsequently provided to a host device.

Operation in 43G DQPSK mode is characterized by the following. Two by 21.5G serial data lanes are received by two input nodes, each input node including a limiting amplifier 803 and 804 and a dedicated CDR 813 and 814. A 21.5 GHz clock signal is recovered for each serial data lane and used to clock the two 21.5G signals into the main demultiplexing block 826. In all other respects, operation in 43G DQPSK mode is similar to operation in 40G VSR and 43G transport modes, with a main demultiplexing block generating 4 X 10.75G data lanes from the two 21.5G signals and encoding the 4 X 10.75 signals into 5 X 10.75G signals which may be provided to a host.

The multi-mode deserializer 800 can be implemented as a single IC. Alternately or additionally, it can be separated across two or more ICs as illustrated by deserializers 252, 254 in Figure 2 and implied by the two receive paths (e.g., data lanes 840-844 and data lanes 845-849) of Figure 8B. For instance, a first IC corresponding to deserializer 252 of Figure 2 (and deserializers 316, 426, 546 and SFI 5.2 transmitters 318, 428, 548 of Figures 3-5) may include input nodes 803, 804, CDRs 813, 814, path selectors 805-807, dynamic demultiplexer 808, retiming flip flops 823-825, dual-mode demultiplexer 826, dual-mode bypass block 830, and output nodes 845-849. The first IC additionally includes its own frequency detector 815 and divider 850.

A second IC corresponding to the deserializer 254 of Figure 2 may include input nodes 801, 802, CDRs 811, 812, retiming flip flops 821, 822, main demultiplexing block 828, optional bypass block 832, output nodes 840-844, frequency detector 815, and divider 850.

In the embodiment just described, wherein the multi-mode deserializer 800 is spread across two ICs, the first IC may be multi-mode while the second IC is single-mode. In particular, in 100G mode the second IC can receive and convert half (e.g., 2) of the 4 X 25G serial data signals from an optical network in a 100G application to five parallel 10G data signals for a host. In this case, the aggregate data rate of the signals received by the first IC from the optical network is 50G since it only receives half of the serial signals. In one or more other modes, the first IC can receive and convert all of the serial data signals (e.g., 1 X 40G, 1 X 43G, or 2 X 21.5G) from an optical network in a 40G VSR, 43G transport, or 43G DQPSK application to five parallel 10G (or 10.75G) data signals for the host, as previously described. In this case, the aggregate data rate of the one or more serial signals received by the first IC from the optical network is 40G (or 43G). Whereas the first IC is a multi-mode IC configured to process half of 4 X 25G serial signals for 100G applications or all of the received serial signals for 40G VSR, 43G transport, and/or 43G DQPSK applications, the second IC can be a single-mode IC configured to process the remaining half of the 4 X 25G serial signals for 100G applications.

With reference now to Figure 9, one embodiment of a dual-mode main demultiplexing block 900 is illustrated which may be used in embodiments of the multi-mode deserializer 800 depicted in Figure 8B. The dual-mode demultiplexer 900 may correspond to the main demultiplexing blocks 826 and/or 828 of Figure 8B.

The dual-mode demultiplexer 900 includes a plurality of input demultiplexers 901 and 902 for receiving a plurality of input data lanes 903 and 904. Each input demultiplexer 901 and 902 can receive a single data lane and generate multiple demultiplexed lanes, the number depending on the mode of operation (100G, 40G or 43G). A mode-selection signal 905 selects the 100G or 40G/43G modes for the input demultiplexers 901 and 902. Two recovered clock signals 906 and 907 are provided by the CDRs 813 and 814 of Figure 8B to the input demultiplexers 901 and 902, respectively.

Coupled to the input demultiplexers are a plurality of synchronizer flip flops 911-915 for clocking the demultiplexed data lanes out of the input demultiplexers 901 and 902 and synchronizing the demultiplexed data lanes. The synchronizer flip flops 911-915 are coupled to a plurality of output multiplexers 921-925. The synchronizer flip flops 911-915 and the output multiplexers 921-925 use a divided down clock 908 supplied by a divider 850 of Figure 8B, which may be a 5 GHz clock for example. Each output multiplexer performs a 2:1 mux function on two data lanes and generates a single data lane.

In 100G mode, the dual-mode demultiplexer 900 receives 2 X 25G data lanes from the initial retiming flip flops 823 and 824 of Figure 8B. The 2 X 25G data lanes are converted to 10 X 5G data lanes (1:5 output mode having been selected by the mode-selection signal 905 for each of the input demultiplexers 901 and 902), synchronized and provided to five 2:1 output multiplexers 921-925. Using a 5GHz clock signal 908, each output multiplexer 921-925 generates a 10G data lane 931-935 from two 5G input lanes. A second dual-mode demultiplexer corresponding to the main demultiplexing block 828 of Figure 8B may similarly receive 2 X 25G data lanes from the initial retiming flip flops 821 and 822 and generate 5 X 10G data lanes.

In 40G VSR (and 43G transport or 43G DQPSK) mode, the dual mode demultiplexer 900 receives 2 X 20G (or 21.5G) data lanes 903 and 904 with the two input demultiplexers 901 and 902. The mode-selection signal 905 configures the input demultiplexers 901 and 902 to perform a 1:4 demux function on the incoming data lanes 903 and 904 by simply not using one of each of their outputs. Thus, the 2 X 20G (or 21.5G) data lanes are converted to 8 X 5G (or 5.375G) data lanes, synchronized and provided to four output multiplexers 921, 922, 924 and 925. Each of the four output multiplexers 921, 922, 924 and 925 generates a 10G (or 10.75G) data lane 931, 932, 934 and 935. Note that the data lane 933 is unused in 40G/43G modes.

### IV. Other Multi-Mode Serializer And Deserializer Configurations And Uses

Embodiments of multi-mode serializers and deserializers have been described with respect to Figures 6 through 9. Each multi-mode serializer or deserializer can be implemented individually on a single IC or on multiple ICs. Further, a multi-mode serializer and deserializer can be implemented together on the same IC or on multiple ICs, at least one of which is shared. Integrated circuits including at least some of the elements of a multi-mode serializer and/or deserializer may be referred to as SerDes ICs.

Advantageously, embodiments of the described multi-mode SerDes may be used in at least two different applications. In this manner, engineering resources and non-recurring engineering costs are significantly reduced. In particular, instead of developing multiple IC chip sets for different applications, only one chip set has to be developed. Additionally, because one chip set addresses the requirements of multiple markets, the resulting higher overall volumes reduce the cost of the ICs and bring in a greater return on research and development investment.

In 100G mode, one or more multi-mode SerDes ICs can map 10 X 10G parallel data lanes to 4 X 25G serial data lanes and vice versa . In 40G VSR, 43G transport and 43G DQPSK modes, one or more SerDes ICs can map 5 X 10G (or 10.75G) parallel data lanes to 1 X 40G (or 43G) or 2 X 21.5G serial data lanes with an optional 21.5 GHz clock, and vice versa. Those skilled in the art will recognize that other multi-mode SerDes ICs may be implemented with different 100G mappings by applying the principles of the present invention, and in particular by making a few changes to the main multiplexing and demultiplexing blocks.

For instance, if the 40G and 43G mode mappings remain the same, a 100G mapping from 12 X 8.33G data lanes to 4 X 25G data lanes can be implemented using a multi-mode serializer with four dual-mode multiplexing blocks that can operate in 3:1 mode for 100G applications and 2:1 mode for 40G/43G applications. This is in contrast to the multi-mode serializer 600 with two dual-mode multiplexing blocks that can operate in 5:2 or 4:2 modes. In the receive direction, 4 X 25G data lanes can be mapped to 12 X 8.33G data lanes using a multi-mode deserializer with four dual-mode demultiplexing blocks that can operate in 1:3 mode for 100G applications and 1:2 mode for 40G/43G applications.

Alternately, a 100G mapping from 8 X 12.5G data lanes to 4 X 25G data lanes can be implemented using a multi-mode serializer with four main multiplexing blocks that operate in 2:1 mode for 100G, 40G, and/or 43G applications. In the receive direction, 4 X 25G data lanes can be mapped to 8 X 12.5G data lanes using a multi-mode deserializer with four main demultiplexing blocks that can operate in 1:2 mode for 100G, 40G and/or 43G applications.

In yet another embodiment, a 100G mapping from 10 X 10G data lanes to 5 X 20G data lanes can be implemented using a multi-mode serializer with five main multiplexing blocks that operate in 2:1 mode for 100G, 40G and/or 43G applications. The receive direction can be implemented using a multi-mode deserializer with five main demultiplexing blocks that can operate in 1:2 mode for 100G, 40G and/or 43G applications. In this embodiment, the CMU of the multi-mode serializer would not require a by 10 multiplier since the by 8 multiplier would be common between 100G, 40G and 43G applications. Similarly, the CDRs of the multi-mode deserializer would not require a by 10 divider since the by 8 divider would be common between 100G, 40G and 43G applications.

The architectures of the described multi-mode SerDes ICs are flexible so that other uses not described herein can take advantage of the architectures. For example, there are several test modes which can make verifying a SerDes IC and the optoelectronic device in which it is used easier. One test mode for 100G applications is to bypass the SFI5.2 receiver 620 and SFI5.2 transmitter 830 of Figures 6 and 8, respectively, but use the main multiplexing blocks 622, 624 and main demultiplexing blocks 826, 828 in 4:2 mode and 2:4 mode, respectively. Normally when the SFI5.2 blocks 620 and 830 are bypassed, the main multiplexing blocks 622 and 624 are operated in 5:2 mode and the main demultiplexing blocks 826 and 828 are operated in 2:5 mode. In this test mode, only eight out of 10 X 10G inputs and eight out of 10 X 10G outputs are used. Each pair of inputs or outputs are then multiplexed to one of the high speed outputs and inputs, and then carried on one optical wavelength and so permit better isolation of how data is affected in the various signal paths.

Another possible SFI5.2 bypass mode (e.g., where the dual-mode bypass blocks 620 and 830 are operating in bypass mode rather than SFI5.2 receive or transmit modes), in combination with the main multiplexing block 622 in 4:2 mode, may include running the final dynamic high speed multiplexer 637 in 40G mode, so that four 10G inputs (out of five actually received by the main multiplexing block 622 during 100G operation) are directly mapped into the 40G output of the high speed multiplexer 637. Similarly, the input dynamic high speed demultiplexer 808 can be run in 40G mode with the main demultiplexing block 826 in 2:4 mode so that a 40G input is directly mapped into a 4 X 10G output of four of the output nodes 845-849.

A test mode with even more signal path isolation would only use four out of the 10 X 10G inputs and four out of the 10 X 10G outputs. The main multiplexing and demultiplexing blocks would be placed in a static mode, simply selecting the desired input. In this way, a single input would be mapped to each high speed output in the multi-mode serializer and each high speed input would be mapped to a single 10G output in the multi-mode deserializer. This way, any of the inputs could be mapped to one of the high speed outputs.

Another additional useful test mode can use the unused high speed outputs in the 40G VSR, 43G transport and 43G DQPSK modes to output a 10 GHz or 10.75 GHz clock. For the 43G transport and 43G DQPSK modes, this would be in addition to the 21.5 GHz clock.

The present invention may be embodied in other specific forms without departing from its spirit or essential characteristics. The described embodiments are to be considered in all respects only as illustrative and not restrictive. The scope of the invention is, therefore, indicated by the appended claims rather than by the foregoing description. All changes which come within the meaning and range of equivalency of the claims are to be embraced within their scope.

## Claims

1. A SerDes configured to support multiple data rates, the SerDes comprising:
a serializer portion (600,650) including:
a first bypass stage (652) configured to: receive a plurality of transmit signals (670), pass the transmit signals unchanged to a multiplexer stage (654) when the transmit signals are at a first aggregate data rate, and decode the transmit signals when the transmit signals are at a second aggregate data rate;
the multiplexer stage (654) coupled with an output of the bypass stage (652) and configured to receive the unchanged transmit signals or the decoded transmit signals and generate a plurality of multiplexed signals (672); and
a dynamic multiplexer (637) configured to: combine two of the multiplexed signals (672) into a single output signal; or pass one of the multiplexed signals through unchanged as one of two or more output signals depending on the aggregate data rate of the transmit signals; and
a deserializer portion (800,860) including:
a demultiplexer stage (866) configured to receive and demultiplex a plurality of retimed signals, the number of retimed signals and the number of demultiplexed signals depending on the aggregate data rate of one or more receive signals (876) received by the deserializer portion (800,860), the one or more receive signals being at the first aggregate data rate or the second aggregate data rate; and
a second bypass stage (868) coupled with the demultiplexer stage (866) and configured to: pass the demultiplexed signals through unchanged when the one or more receive signals are at the first aggregate data rate or encode the demultiplexed signals when the one or more receive signals are at the second aggregate data rate.

2. The SerDes of claim 1, wherein the first aggregate data rate is substantially equal to 100 gigabits per second and the second aggregate data rate is substantially equal to one or more of:
40 gigabits per second very short range;
43 gigabits per second transport; and
43 gigabits per second DQPSK.

3. The SerDes of claim 2, wherein:
the dynamic multiplexer (637) is configured to combine two multiplexed signals to obtain a single serial signal when the aggregate data rate of the transmit signals is 40 gigabits per second very short range or 43 gigabits per second transport; and
the dynamic multiplexer is configured to pass through one of the multiplexed signals when the aggregate data rate of the transmit signals is 100 gigabits per second or 43 gigabits per second DQPSK.

4. The SerDes of claim 2, wherein:
the demultiplexer stage (866) is configured to receive two retimed signals and generate four demultiplexed signals when the aggregate data rate of the one or more receive signals is substantially equal to 40 gigabits per second very short range, 43 gigabits per second transport or 43 gigabits per second DQPSK, and
the demultiplexer stage is configured to receive four retimed signals and generate ten demultiplexed signals when the aggregate data rate of the one or more receive signals is substantially equal to 100 gigabits per second.

5. The SerDes of claim 2, wherein the deserializer portion (800,860) is configured to implement one or more of the following mappings from one or more receive signals to demultiplexed signals at the first aggregate data rate and the serializer portion is configured to implement an inverse mapping from transmit signals to one or more output signals:
four receive signals having data rates substantially equal to 25 gigabits per second to ten demultiplexed signals having data rates substantially equal to 10 gigabit per second;
four receive signals having data rates substantially equal to 25 gigabits per second to twelve demultiplexed signals having data rates substantially equal to 8.33 gigabits per second;
four receive signals having data rates substantially equal to 25 gigabits per second to eight demultiplexed signals having data rate rates substantially equal to 12.5 gigabits per second; or
five receive signals having data rates substantially equal to 20 gigabits per second to ten demultiplexed signals having data rates substantially equal to 10 gigabits per second.

6. The SerDes of claim 2, wherein the deserializer portion (800,860) is configured to perform one or more of:
map one receive signal having a data rate substantially equal to 40 gigabits per second to five encoded signals each having a data rate substantially equal to 10 gigabits per second and the serializer portion is configured to map five transmit signals each having a data rate substantially equal to 10 gigabits per second to one output signal having a data rate substantially equal to 40 gigabits per second;
map one receive signal having a data rate substantially equal to 43 gigabits per second to five encoded signals each having a data rate substantially equal to 10.75 gigabits per second and the serializer portion is configured to map five transmit signals each having a data rate substantially equal to 10.75 gigabits per second to one output signal having a data rate substantially equal to 40 gigabits per second and a 21.5 gigahertz clock signal; or
map two receive signals each having a data rate substantially equal to 21.5 gigabits per second to five encoded signals each having a data rate substantially equal to 10.75 gigabits per second and the serializer portion is configured to map five transmit signals each having a data rate substantially equal to 10.75 gigabits per second to two output signals each having a data rate substantially equal to 21.5 gigabits per second and a 21.5 gigahertz clock signal.

7. The SerDes as recited in any of claims 1-6, wherein the serializer portion (600,650) and deserializer portion (800,860) are implemented together on the same integrated circuit, IC.

8. A multi-channel optoelectronic device (200) including first and second SerDes, at least one of the first and second SerDes comprising the SerDes of any of claims 1-6.

9. The multi-channel optoelectronic device (200) as recited in claim 8, wherein a deserializer of the first SerDes and a deserializer of the second SerDes are implemented on different respective integrated circuits, IC.

10. The multi-channel optoelectronic device (200) as recited in claim 8, wherein a serializer of the first SerDes and a serializer of the second SerDes are implemented together on the same integrated circuit, IC.

11. The multi-channel optoelectronic device (200) as recited in claim 8, wherein a serializer of the first SerDes and a serializer of the second SerDes are implemented on different respective integrated circuits, IC.

12. The multi-channel optoelectronic device (200) as recited in claim 8, wherein at least one deserializer and at least one serializer are implemented together on the same integrated circuit, IC.

13. The multi-channel optoelectronic device (200) as recited in claim 8, wherein the serializer portion includes a plurality of outputs, each of which is coupled to a respective modulation driver (206,208,212,214), each modulation driver being coupled to a respective electro-optical transducer (216,218,222,224), and an optical multiplexer (226) coupled to the electro-optical transducers.

## Patentansprüche

1. SerDes, der ausgelegt ist zum Unterstützen von mehreren Datenraten, wobei der SerDes Folgendes umfasst:
einen Serialisiererabschnitt (600, 650), der Folgendes beinhaltet:
eine erste Umgehungsstufe (652), die ausgelegt ist zum Empfangen mehrerer Sendesignale (670), unveränderten Übermitteln der Sendesignale zu einer Multiplexerstufe (654), wenn sich die Sendesignale bei einer ersten Aggregat-Datenrate befinden, und Decodieren der Sendesignale, wenn sich die Sendesignale bei einer zweiten Aggregat-Datenrate befinden;
die Multiplexerstufe (654), die mit einem Ausgang der Umgehungsstufe (652) gekoppelt ist und ausgelegt ist zum Empfangen der unveränderten Sendesignale oder der decodierten Sendesignale und zum Erzeugen mehrerer gemultiplexter Signale (672); und
einen dynamischen Multiplexer (637), der ausgelegt ist zum Kombinieren von zwei der gemultiplexten Signale (672) in ein einziges Ausgangssignal oder Durchleiten von einem der gemultiplexten Signale unverändert als eines von zwei oder mehreren Ausgangssignalen in Abhängigkeit von der Aggregat-Datenrate der Sendesignale; und
einen Deserialisiererabschnitt (800, 860), der Folgendes beinhaltet:
eine Demultiplexerstufe (866), die ausgelegt ist zum Empfangen und Demultiplexen mehrerer neugetimter Signale, wobei die Anzahl von neugetimten Signalen und die Anzahl von demultiplexten Signalen von der Aggregat-Datenrate von einem oder mehreren Empfangssignalen (876), die durch den Deserialisiererabschnitt (800, 860) empfangen werden, abhängen, wobei sich das eine oder die mehreren Empfangssignale bei der ersten Aggregat-Datenrate oder der zweiten Aggregat-Datenrate befinden; und
eine zweite Umgehungsstufe (868), die mit der Demultiplexerstufe (866) gekoppelt ist und ausgelegt ist zum unveränderten Durchleiten der demultiplexten Signale, wenn sich das eine oder die mehreren Empfangssignale bei der ersten Aggregat-Datenrate befinden, oder Codieren der demultiplexten Signale, wenn sich das eine oder die mehreren Empfangssignale bei der zweiten Aggregat-Datenrate befinden.

2. SerDes nach Anspruch 1, wobei die erste Aggregat-Datenrate im Wesentlichen gleich 100 Gigabit pro Sekunde ist und die zweite Aggregat-Datenrate im Wesentlichen gleich einem oder mehreren der Folgenden ist:
40 Gigabit pro Sekunde bei sehr kurzer Reichweite;
43 Gigabit pro Sekunde bei Transport und
43 Gigabit pro Sekunde bei DQPSK.

3. SerDes nach Anspruch 2, wobei:
der dynamische Multiplexer (637) ausgelegt ist zum Kombinieren von zwei gemultiplexten Signalen, um ein einziges serielles Signal zu erhalten, wenn die Aggregat-Datenrate der Sendesignale 40 Gigabit pro Sekunde bei sehr kurzer Reichweite oder 43 Gigabit pro Sekunde bei Transport ist; und
der dynamische Multiplexer ausgelegt ist zum Durchleiten von einem der gemultiplexten Signale, wenn die Aggregat-Datenrate der Sendesignale 100 Gigabit pro Sekunde oder 43 Gigabit pro Sekunde bei DQPSK ist.

4. SerDes nach Anspruch 2, wobei:
die Demultiplexerstufe (866) ausgelegt ist zum Empfangen von zwei neugetimten Signalen und Erzeugen von vier demultiplexten Signalen, wenn die Aggregat-Datenrate des einen oder der mehreren Empfangssignale im Wesentlichen gleich 40 Gigabit pro Sekunde bei sehr kurzer Reichweite, 43 Gigabit pro Sekunde bei Transport oder 43 Gigabit pro Sekunde bei DQPSK ist, und
die Demultiplexerstufe ausgelegt ist zum Empfangen von vier neugetimten Signalen und Erzeugen von zehn demultiplexten Signalen, wenn die Aggregat-Datenrate des einen oder der mehreren Empfangssignale im Wesentlichen gleich 100 Gigabit pro Sekunde ist.

5. SerDes nach Anspruch 2, wobei der Deserialisiererabschnitt (800, 860) ausgelegt ist zum Implementieren von einer oder mehreren der folgenden Abbildungen von einem oder mehreren Empfangssignalen zu demultiplexten Signalen bei der ersten Aggregat-Datenrate und der Serialisiererabschnitt ausgelegt ist zum Implementieren einer inversen Abbildung von Sendesignalen zu einem oder mehreren Ausgangssignalen:
vier Empfangssignale mit Datenraten im Wesentlichen gleich 25 Gigabit pro Sekunde zu zehn demultiplexten Signalen mit Datenraten im Wesentlichen gleich 10 Gigabit pro Sekunde;
vier Empfangssignale mit Datenraten im Wesentlichen gleich 25 Gigabit pro Sekunde zu zwölf demultiplexten Signalen mit Datenraten im Wesentlichen gleich 8,33 Gigabit pro Sekunde;
vier Empfangssignale mit Datenraten im Wesentlichen gleich 25 Gigabit pro Sekunde zu acht demultiplexten Signalen mit Datenraten im Wesentlichen gleich 12,5 Gigabit pro Sekunde oder fünf Empfangssignale mit Datenraten im Wesentlichen gleich 20 Gigabit pro Sekunde zu zehn demultiplexten Signalen mit Datenraten im Wesentlichen gleich 10 Gigabit pro Sekunde.

6. SerDes nach Anspruch 2, wobei der Deserialisiererabschnitt (800, 860) zum Durchführen von einem oder mehreren der Folgenden ausgelegt ist:
Abbilden eines Empfangssignals mit einer Datenrate im Wesentlichen gleich 40 Gigabit pro Sekunde zu fünf codierten Signalen mit jeweils einer Datenrate im Wesentlichen gleich 10 Gigabit pro Sekunde, und der Serialisiererabschnitt ausgelegt ist zum Abbilden von fünf Sendesignalen jeweils mit einer Datenrate im Wesentlichen gleich 10 Gigabit pro Sekunde zu einem Ausgangssignal mit einer Datenrate im Wesentlichen gleich 40 Gigabit pro Sekunde;
Abbilden eines Empfangssignals mit einer Datenrate im Wesentlichen gleich 43 Gigabit pro Sekunde zu fünf codierten Signalen mit jeweils einer Datenrate im Wesentlichen gleich 10,75 Gigabit pro Sekunde, und der Serialisiererabschnitt ausgelegt ist zum Abbilden von fünf Sendesignalen mit jeweils einer Datenrate im Wesentlichen gleich 10,75 Gigabit pro Sekunde zu einem Ausgangssignal mit einer Datenrate im Wesentlichen gleich 40 Gigabit pro Sekunde und einem Taktsignal mit 21,5 Gigahertz; oder
Abbilden von zwei Empfangssignalen mit jeweils einer Datenrate im Wesentlichen gleich 21,5 Gigabit pro Sekunde zu fünf codierten Signalen mit jeweils einer Datenrate im Wesentlichen gleich 10,75 Gigabit pro Sekunde, und der Serialisiererabschnitt ausgelegt ist zum Abbilden von fünf Sendesignalen mit jeweils einer Datenrate im Wesentlichen gleich 10,75 Gigabit pro Sekunde zu zwei Ausgangssignalen mit jeweils einer Datenrate im Wesentlichen gleich 21,5 Gigabit pro Sekunde und einem Taktsignal mit 21,5 Gigahertz.

7. SerDes nach einem der Ansprüche 1-6, wobei der Serialisiererabschnitt (600, 650) und der Deserialisiererabschnitt (800, 860) zusammen auf demselben integrierten Schaltkreis bzw. IC implementiert sind.

8. Optoelektronische Einrichtung (200) mit mehreren Kanälen, die einen ersten und einen zweiten SerDes beinhaltet, wobei der erste und/oder der zweite SerDes den SerDes nach einem der Ansprüche 1-6 umfasst.

9. Optoelektronische Einrichtung (200) mit mehreren Kanälen nach Anspruch 8, wobei ein Deserialisierer des ersten SerDes und ein Deserialisierer des zweiten SerDes auf unterschiedlichen jeweiligen integrierten Schaltkreisen bzw. IC implementiert sind.

10. Optoelektronische Einrichtung (200) mit mehreren Kanälen nach Anspruch 8, wobei ein Serialisierer des ersten SerDes und ein Serialisierer des zweiten SerDes zusammen auf demselben integrierten Schaltkreis bzw. IC implementiert sind.

11. Optoelektronische Einrichtung (200) mit mehreren Kanälen nach Anspruch 8, wobei ein Serialisierer des ersten SerDes und ein Serialisierer des zweiten SerDes auf unterschiedlichen jeweiligen integrierten Schaltkreisen bzw. IC implementiert sind.

12. Optoelektronische Einrichtung (200) mit mehreren Kanälen nach Anspruch 8, wobei mindestens ein Deserialisierer und mindestens ein Serialisierer zusammen auf demselben integrierten Schaltkreis bzw. IC implementiert sind.

13. Optoelektronische Einrichtung (200) mit mehreren Kanälen nach Anspruch 8, wobei der Serialisiererabschnitt mehrere Ausgänge, die jeweils mit einem jeweiligen Modulationstreiber (206, 208, 212, 214) gekoppelt sind, wobei jeder Modulationstreiber mit einem jeweiligen elektrooptischen Transducer (216, 218, 222, 224) gekoppelt ist, und einen optischen Multiplexer (226), der mit den elektrooptischen Transducern gekoppelt ist, beinhaltet.

## Revendications

1. SerDes conçu pour prendre en charge de multiples taux de données, le SerDes comprenant :
une partie sérialiseur (600, 650) comprenant :
un premier étage de contournement (652) conçu pour : recevoir une pluralité de signaux de transmission (670), faire passer les signaux de transmission inchangés vers un étage multiplexeur (654) lorsque les signaux de transmission sont à un premier taux de données d'agrégat, et décoder les signaux de transmission lorsque les signaux de transmission sont à un second taux de données d'agrégat ;
l'étage multiplexeur (654) couplé à une sortie de l'étage de contournement (652) et conçu pour recevoir les signaux de transmission inchangés ou les signaux de transmission décodés et générer une pluralité de signaux multiplexés (672) ; et
un multiplexeur dynamique (637) conçu pour : combiner deux des signaux multiplexés (672) en un signal de sortie unique ; ou laisser passer un des signaux multiplexés inchangés en tant qu'un de deux signaux de sortie ou plus en fonction du taux de données d'agrégat des signaux de transmission ; et
une partie désérialiseur (800, 860) comprenant :
un étage démultiplexeur (866) conçu pour recevoir et démultiplexer une pluralité de signaux resynchronisés, le nombre de signaux resynchronisés et le nombre de signaux démultiplexés dépendant du taux de données d'agrégat d'un ou de plusieurs signaux de réception (876) reçus par la partie désérialiseur (800, 860), le ou les signaux de réception étant au premier taux de données d'agrégat ou au second taux de données d'agrégat ; et
un second étage de contournement (866) couplé à l'étage démultiplexeur (866) et conçu pour : laisser passer les signaux démultiplexés inchangés lorsque le ou les signaux de réception sont au premier taux de données d'agrégat ou coder les signaux démultiplexés lorsque le ou les signaux de réception sont au second taux de données d'agrégat.

2. SerDes selon la revendication 1, dans lequel le premier taux de données d'agrégat est essentiellement égal à 100 gigabits par seconde et le second taux de données d'agrégat est essentiellement égal à un ou plusieurs de :
40 gigabits par seconde très courte portée ;
43 gigabits par seconde transport ; et
43 gigabits par seconde DQPSK.

3. SerDes selon la revendication 2, dans lequel :
le multiplexeur dynamique (637) est conçu pour combiner deux signaux multiplexés pour obtenir un signal série unique lorsque le taux de données d'agrégat des signaux de transmission est de 40 gigabits par seconde très courte portée ou 43 gigabits par seconde transport ; et
le multiplexeur dynamique est conçu pour laisser passer un des signaux multiplexés lorsque le taux de données d'agrégat des signaux de transmission est de 100 gigabits par seconde ou 43 gigabits par seconde DQPSK.

4. SerDes selon la revendication 2, dans lequel :
l'étage démultiplexeur (866) est conçu pour recevoir deux signaux resynchronisés et générer quatre signaux démultiplexés lorsque le taux de données d'agrégat du ou des signaux de réception est essentiellement égal à 40 gigabits par seconde très courte portée, 43 gigabits par seconde transport ou 43 gigabits par seconde DQPSK ; et
l'étage démultiplexeur est conçu pour recevoir quatre signaux resynchronisés et générer dix signaux démultiplexés lorsque le taux de données d'agrégat du ou des signaux de réception est essentiellement égal à 100 gigabits par seconde.

5. SerDes selon la revendication 2, dans lequel la partie désérialiseur (800, 860) est conçue pour mettre en oeuvre une ou plusieurs des cartographies suivantes à partir d'un ou de plusieurs signaux de réception en signaux démultiplexés au premier taux de données d'agrégat et la partie sérialiseur est conçue pour mettre en oeuvre une cartographie inverse à partir de signaux de transmission en un ou plusieurs signaux de sortie :
quatre signaux de réception ayant des taux de données essentiellement égaux à 25 gigabits par seconde en dix signaux démultiplexés ayant des taux de données essentiellement égaux à 10 gigabits par seconde ;
quatre signaux de réception ayant des taux de données essentiellement égaux à 25 gigabits par seconde en douze signaux démultiplexés ayant des taux de données essentiellement égaux à 8,33 gigabits par seconde ;
quatre signaux de réception ayant des taux de données essentiellement égaux à 25 gigabits par seconde en huit signaux démultiplexés ayant des taux de données essentiellement égaux à 12,5 gigabits par seconde ; ou
cinq signaux de réception ayant des taux de données essentiellement égaux à 20 gigabits par seconde en dix signaux démultiplexés ayant des taux de données essentiellement égaux à 10 gigabits par seconde.

6. SerDes selon la revendication 2, dans lequel la partie désérialiseur (800, 860) est conçue pour effectuer une ou plusieurs des opérations suivantes :
cartographier un signal de réception ayant un taux de données essentiellement égal à 40 gigabits par seconde en cinq signaux codés ayant chacun un taux de données essentiellement égal à 10 gigabits par seconde, et la partie sérialiseur est conçue pour cartographier cinq signaux de transmission ayant chacun un taux de données essentiellement égal à 10 gigabits par seconde en un signal de sortie ayant un taux de données essentiellement égal à 40 gigabits par seconde ;
cartographier un signal de réception ayant un taux de données essentiellement égal à 43 gigabits par seconde en cinq signaux codés ayant chacun un taux de données essentiellement égal à 10,75 gigabits par seconde, et la partie sérialiseur est conçue pour cartographier cinq signaux de transmission ayant chacun un taux de données essentiellement égal à 10,75 gigabits par seconde en un signal de sortie ayant un taux de données essentiellement égal à 40 gigabits par seconde, et un signal d'horloge à 21,5 gigahertz ; ou
cartographier deux signaux de réception ayant chacun un taux de données essentiellement égal à 21,5 gigabits par seconde en cinq signaux codés ayant chacun un taux de données essentiellement égal à 10,75 gigabits par seconde, et la partie sérialiseur est conçue pour cartographier cinq signaux de transmission ayant chacun un taux de données essentiellement égal à 10,75 gigabits par seconde en deux signaux de sortie ayant chacun un taux de données essentiellement égal à 21,5 gigabits par seconde, et un signal d'horloge à 21,5 gigahertz.

7. SerDes selon l'une quelconque des revendications 1 à 6, dans lequel la partie sérialiseur (600, 650) et la partie désérialiseur (800, 860) sont mises en oeuvre ensemble sur le même circuit intégré IC.

8. Dispositif optoélectronique multicanal (200) comprenant des premier et second SerDes, l'un au moins des premier et second SerDes comprenant le SerDes selon l'une quelconque des revendications 1 à 6.

9. Dispositif optoélectronique multicanal (200) selon la revendication 8, dans lequel un désérialiseur du premier SerDes et un désérialiseur du second SerDes sont mis en oeuvre sur des circuits intégrés IC respectifs différents.

10. Dispositif optoélectronique multicanal (200) selon la revendication 8, dans lequel un sérialiseur du premier SerDes et un sérialiseur du second SerDes sont mis en oeuvre ensemble sur le même circuit intégré IC.

11. Dispositif optoélectronique multicanal (200) selon la revendication 8, dans lequel un sérialiseur du premier SerDes et un sérialiseur du second SerDes sont mis en oeuvre sur des circuits intégrés IC respectifs différents.

12. Dispositif optoélectronique multicanal (200) selon la revendication 8, dans lequel au moins un désérialiseur et au moins un sérialiseur sont mis en oeuvre ensemble sur le même circuit intégré IC.

13. Dispositif optoélectronique multicanal (200) selon la revendication 8, dans lequel la partie sérialiseur comprend une pluralité de sorties, chacune d'entre elles étant couplée à un actionneur de modulation respectif (206, 208, 212, 214), chaque actionneur de modulation étant couplé à un transducteur électrooptique respectif (216, 218, 222, 224), et un multiplexeur optique (226) couplé aux transducteurs électrooptiques.
